(19) Europäisches Patentamt
European Patent Office
Office européen des brevets

(11) **EP 4 429 095 A1**

(12) **DEMANDE DE BREVET EUROPEEN**

(43) Date de publication:
**11.09.2024 Bulletin 2024/37**

(51) Classification Internationale des Brevets (IPC):
**H02M 3/335** *(2006.01)* **H01L 29/20** *(2006.01)*

(21) Numéro de dépôt: **24160121.0**

(52) Classification Coopérative des Brevets (CPC):
**H02M 3/33507;** H01L 29/2003

(22) Date de dépôt: **28.02.2024**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **08.03.2023 FR 2302129**

(71) Demandeur: **STMicroelectronics International N.V.**
**1228 Plan-les-Ouates, Geneva (CH)**

(72) Inventeurs:
• **ESTEVE, Lionel**
**13111 COUDOUX (FR)**
• **BOURGUINE, Loic**
**13790 CHATEAUNEUF LE ROUGE (FR)**

(74) Mandataire: **Cabinet Beaumont**
**4, Place Robert Schuman**
**B.P. 1529**
**38025 Grenoble Cedex 1 (FR)**

(54) **CIRCUIT DE MODULATION DE LARGEUR D'IMPULSION**

(57) La présente description concerne un circuit de modulation de largeur d'impulsion (405) d'une alimentation à découpage (400) formé dans et sur un substrat semiconducteur monolithique ayant une face recouverte d'une couche de Nitrure de Gallium, ledit circuit étant adapté à commander un transistor de puissance (404) de ladite alimentation à découpage.

Fig. 4

EP 4 429 095 A1

## Description

Domaine technique

La présente description concerne de façon générale les systèmes et dispositifs électroniques, et plus particulièrement les systèmes et dispositifs électroniques formées à partir d'une structure de Nitrure de Gallium (GaN). La présente description se rapporte plus particulièrement à un commutateur de puissance formé à partir d'une structure de Nitrure de Gallium (GaN) et utilisé dans une alimentation à découpage.

Technique antérieure

Il est classique de former des systèmes et des dispositifs électroniques à partir de substrat en silicium, mais d'autres matériaux semiconducteurs peuvent être utilisés. En particulier, des structures comprenant du Nitrure de Gallium (GaN) peuvent être utilisées.

Il serait souhaitable de pouvoir améliorer, au moins en partie, certains aspects des systèmes et dispositifs électroniques formés à partir dans et sur des structures comprenant du Nitrure de Gallium.

Résumé de l'invention

Il existe un besoin pour des systèmes et dispositifs électroniques formés dans et sur des structures comprenant du Nitrure de Gallium.

Il existe un besoin pour des systèmes et dispositifs électroniques comprenant des transistors formés dans et sur des structures comprenant du Nitrure de Gallium.

Un mode de réalisation pallie tout ou partie des inconvénients des systèmes et dispositifs électroniques connus.

Selon un premier aspect, un mode de réalisation prévoit un circuit de modulation de largeur d'impulsion d'une alimentation à découpage formé dans et sur un substrat semiconducteur monolithique ayant une face recouverte d'une couche de Nitrure de Gallium, ledit circuit étant adapté à commander un transistor de puissance de ladite alimentation à découpage.

Selon un mode de réalisation, le circuit comprend un premier circuit comparateur d'une première tension représentative d'un courant de drain dudit transistor et d'un courant de rétroaction de ladite alimentation à découpage.

Selon un mode de réalisation, ledit premier circuit comparateur est adapté à rendre ledit transistor non conducteur si ladite première tension est supérieure à une première tension de seuil.

Selon un mode de réalisation, le circuit comprend, en outre, un deuxième circuit comparateur de ladite première tension représentative du courant de drain dudit transistor et d'un courant de rétroaction de ladite alimentation à découpage.

Selon un mode de réalisation, ledit deuxième circuit comparateur est adapté à rendre ledit transistor non conducteur si ladite première tension est inférieure à une deuxième tension de seuil.

Selon un mode de réalisation, le circuit comprend, en outre, un premier circuit de filtrage permettant de ne prendre en compte un résultat dudit deuxième circuit comparateur uniquement pendant une phase de non-conduction dudit transistor de puissance.

Selon un mode de réalisation, le circuit comprend, en outre, un troisième circuit comparateur de ladite première tension représentative du courant de drain dudit transistor et d'un courant de rétroaction de ladite alimentation à découpage.

Selon un mode de réalisation, ledit troisième circuit comparateur est adapté à rendre ledit transistor non conducteur si ladite première tension est supérieure à une troisième tension de seuil.

Selon un mode de réalisation, le circuit comprend, en outre, un deuxième circuit de filtrage permettant de ne prendre en compte un résultat dudit troisième circuit comparateur uniquement pendant une phase de non-conduction dudit transistor de puissance.

Selon un mode de réalisation, le circuit comprend, en outre, un circuit oscillant adapté à fournir une tension d'horloge.

Selon un mode de réalisation, le circuit comprend, en outre, un circuit logique adapté à recevoir au moins une tension d'horloge, et au moins une tension de comparaison .

Selon un mode de réalisation, le circuit comprend, en outre un circuit de pilotage dudit transistor de puissance adapté à recevoir une tension de commande dudit circuit logique.

Un autre mode de réalisation prévoit un commutateur de puissance comprenant un transistor de puissance adapté à recevoir une tension maximale de 650 V entre son drain et sa source, et un circuit de modulation en largeur d'impulsion décrit précédemment.

Selon un mode de réalisation, ledit transistor de puissance est un transistor de type HEMT de type e-mode.

Un autre mode de réalisation prévoit une alimentation à découpage comprenant le commutateur de puissance décrit précédemment.

Selon un deuxième aspect, un mode de réalisation prévoit un circuit de détection d'un court-circuit de sortie d'une alimentation à découpage, formé dans et sur un substrat semiconducteur monolithique ayant une face recouverte d'une couche de Nitrure de Gallium, ledit circuit étant adapté à commander un transistor de puissance de ladite alimentation à découpage.

Selon un mode de réalisation, le circuit comprend, un circuit comparateur d'une première tension représentative du courant de drain dudit transistor et d'un courant de rétroaction de ladite alimentation à découpage.

Selon un mode de réalisation, ledit circuit comparateur est adapté à rendre ledit transistor non conducteur si ladite première tension est inférieure à une deuxième tension de seuil.

Selon un mode de réalisation, le circuit comprend, en outre, un premier circuit de filtrage permettant de ne prendre en compte un résultat dudit circuit comparateur uniquement pendant une phase de non-conduction dudit transistor de puissance.

Selon un mode de réalisation, le circuit comprend, en outre, un circuit oscillant adapté à fournir une tension d'horloge à basse fréquence.

Un autre mode de réalisation prévoit un circuit de modulation de largeur d'impulsion comprenant un circuit de détection d'un court-circuit décrit précédemment.

Selon un mode de réalisation, le circuit comprend, en outre, un circuit logique adapté à recevoir une tension de comparaison fournie par ledit circuit de détection.

Selon un mode de réalisation, le circuit comprend, en outre un circuit de pilotage dudit transistor de puissance adapté à recevoir une tension de commande dudit circuit logique.

Un autre mode de réalisation prévoit un commutateur de puissance comprenant un transistor de puissance adapté à recevoir une tension maximale de 650 V entre son drain et sa source, et un circuit de modulation en largeur d'impulsion décrit précédemment.

Selon un mode de réalisation, ledit transistor de puissance est un transistor de type HEMT de type e-mode.

Un autre mode de réalisation prévoit une alimentation à découpage comprenant le commutateur de puissance décrit précédemment.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

La figure 1 représente, très schématiquement, une structure comprenant du Nitrure de Gallium ;

la figure 2 comprend deux vues (A) et (B) illustrant un premier type de transistor formé dans et sur une structure comprenant du Nitrure de Gallium ;

la figure 3 représente comprend deux vues (A) et (B) illustrant un deuxième type de transistor formé dans une structure comprenant du Nitrure de Gallium ;

la figure 4 représente, schématiquement et partiellement sous forme de blocs, une partie d'une alimentation à découpage comprenant un mode de réalisation d'un dispositif électronique formé dans et sur une structure comprenant du Nitrure de Gallium ;

la figure 5 représente, schématiquement et sous forme de blocs, un schéma électrique plus détaillé d'un mode de réalisation d'un commutateur de puissance de l'alimentation à découpage de la figure 4 ;

la figure 6 représente un exemple de réalisation d'un circuit logique du mode de réalisation de la figure 5 ;

la figure 7 représente un mode de réalisation d'un circuit oscillant du mode de réalisation de la figure 5 ;

la figure 8 représente des chronogrammes illustrant le fonctionnement du circuit oscillant de la figure 7 ;

la figure 9 représente un exemple de réalisation d'un circuit comparateur ;

la figure 10 représente un premier mode de réalisation d'un circuit comparateur de courant du mode de réalisation de la figure 5 ;

la figure 11 représente des chronogrammes illustrant le fonctionnement du circuit comparateur de courant de la figure 10 ;

la figure 12 représente une courbe illustrant le fonctionnement du circuit comparateur de courant de la figure 10 ;

la figure 13 représente un deuxième mode de réalisation d'un circuit comparateur de courant du mode de réalisation de la figure 5 ;

la figure 14 représente des chronogrammes illustrant le fonctionnement du circuit comparateur de courant de la figure 13, et en particulier un mode de fonctionnement à démarrage lent du seuil de déclenchement du comparateur ;

la figure 15 représente un mode de réalisation d'un circuit de détection d'une charge de sortie ouverte du mode de réalisation de la figure 5 ;

la figure 16 représente des chronogrammes illustrant le fonctionnement du circuit de détection d'une charge de sortie ouverte de la figure 15 ;

la figure 17 représente un mode de réalisation d'un circuit de filtrage du mode de réalisation de la figure 15 ;

la figure 18 représente des chronogrammes illustrant le fonctionnement du circuit de filtrage de la figure 17 ;

la figure 19 représente un mode de réalisation d'un circuit de génération d'un signal de commande du circuit de filtrage de la figure 17 ;

la figure 20 représente des chronogrammes illustrant le fonctionnement du circuit de génération de la figure 19 ;

la figure 21 représente un mode de réalisation d'un circuit de détection d'un court-circuit en sortie de l'alimentation à découpage comprenant le mode de réalisation de la figure 5 ;

la figure 22 représente des chronogrammes illustrant le fonctionnement du circuit de détection d'un court-circuit de sortie de la figure 21 ;

la figure 23 représente, plus en détail, une partie du mode de réalisation du circuit de détection d'un court-circuit de sortie de la figure 21 ;

la figure 24 représente des chronogrammes illustrant le fonctionnement une partie du mode de réalisation du circuit de détection d'un court-circuit de sortie de la figure 23, et en particulier le principe de limitation de puissance de la détection d'un court-circuit en sortie et les redémarrages associés ;

la figure 25 représente un premier mode de réalisation d'un circuit de génération de tensions de seuil du mode de réalisation de la figure 5 ;

la figure 26 représente un deuxième mode de réalisation d'un circuit de génération de tensions de seuil du mode de réalisation de la figure 5 ; et

la figure 27 représente un exemple de réalisation plus détaillé du mode de réalisation de la figure 4.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.
Par souci de clarté, seuls les étapes et éléments utiles à la compréhension des modes de réalisation décrits ont été représentés et sont détaillés.
Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

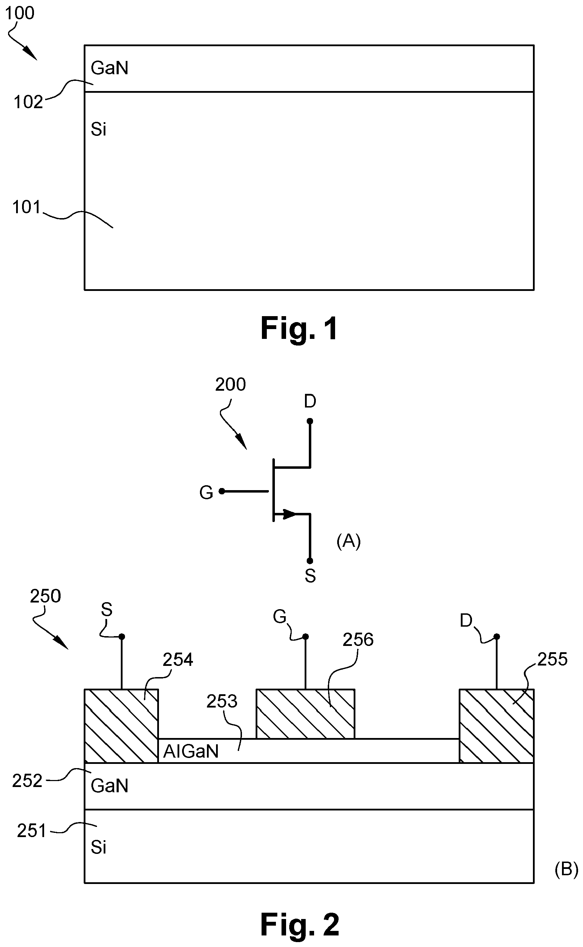

La figure 1 est une vue en coupe représentant très schématiquement une structure semiconductrice 100 comprenant du Nitrure de Gallium.

La structure 100 est généralement composée d'un substrat 101 (Si) en un matériau semiconducteur, par exemple un substrat en silicium, recouvert sur une de ses faces d'une couche 102 (GaN) en Nitrure de Gallium (GaN). La couche 102 a une épaisseur comprise entre 0,5 et 5 $\mu$m.

Lorsque la structure 100 est utilisée comme base d'un système ou d'un dispositif électronique, des composants électroniques sont formées dans et sur la couche 102. Des niveaux de métallisations peuvent, en outre, être formés sur la couche 102.

La figure 2 comprend deux vues (A) et (B) illustrant un premier type de transistor 200 formé dans une structure comprenant du Nitrure de Gallium. La vue (A) représente un schéma électrique du transistor 200, et la vue (B) représente une vue en coupe d'une structure 250 formant le transistor 200.

Le transistor 200 est un transistor à électron à haute mobilité (High Electron Mobility Transistor, HEMT), aussi appelé transistor à effet de champ à dopage modulé (modulated-doping field effect transistor, MODFET). Ci-après un transistor à électrons à haute mobilité est appelé transistor HEMT.

Un transistor HEMT, comme le transistor 200, comprend, une borne de grille, notée G en figure 2, une borne de source, notée S en figure 2, et une borne de drain, notée D en figure 2.

De plus, le transistor 200 est un transistor HEMT à mode de déplétion (depletion mode), appelé ci-après transistor HEMT de type d-mode, ou transistor d-mode. Selon une autre appellation, le transistor 200 est un transistor HEMT de type normalement ON (normally-ON), ou transistor HEMT normalement ON, ou transistor normalement ON. Le schéma électrique du transistor 200 présenté en vue (A) est le schéma électrique qui sera utilisé dans toutes les figures suivantes pour représenter un transistor d-mode ou normalement ON.

En pratique, le transistor 200 peut être obtenu par une structure 250 formée à partir d'une structure du type de la structure 100 décrite en relation avec la figure 1. Ainsi, la structure 250 comprend un substrat 251 (Si) en un matériau conducteur, comme du silicium, dont une face est recouverte par une couche 252 (GaN) en Nitrure de Gallium. La couche 252 en Nitrure de Gallium est partiellement recouverte par une couche 253 (AlGaN) en Nitrure d'Aluminium-Gallium. Une borne de connexion 254 forme la prise de contact de source S du transistor 200. La borne de connexion 254 est formée sur une portion de la couche 252 qui n'est pas recouverte de la couche 253. Une borne de connexion 255 forme la prise de contact de drain D du transistor 200. La borne de connexion 255 est formée sur une portion de la couche 252 qui n'est pas recouverte de la couche 253. Une borne de connexion 256 forme la prise de contact de grille G du transistor 200. La borne de connexion 256 est formée sur une portion de la couche 253, et est disposé entre les plots de connexion 254 et 255.

Le fonctionnement du transistor 200 est le suivant. Lorsque la grille G du transistor 200 est laissé flottante, ou qu'une tension positive est appliquée entre sa grille G et sa source S, le transistor 200 est passant ou conducteur, d'où son appellation de transistor normalement ON. Pour "fermer" le transistor 200, c'est-à-dire le rendre non conducteur, une tension négative doit être appliquée entre sa grille G et sa source S.

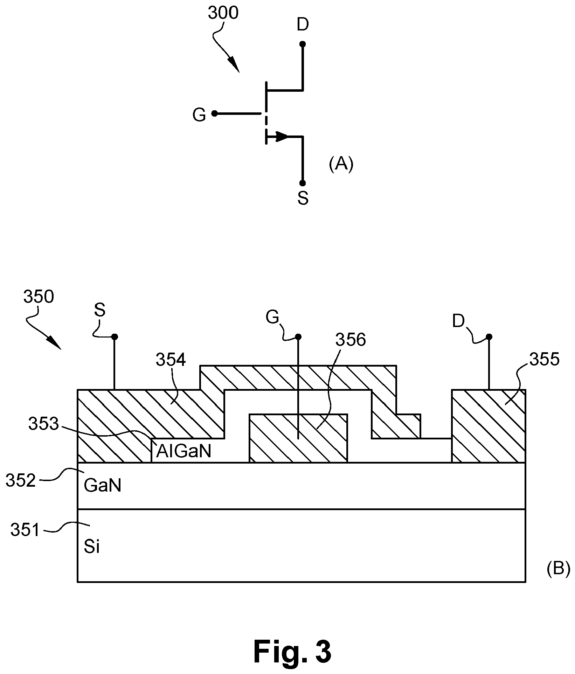

La figure 3 comprend deux vues (A) et (B) illustrant un deuxième type de transistor 300 formé dans une structure comprenant du Nitrure de Gallium. La vue (A) représente un schéma électrique du transistor 300, et la vue (B) représente une vue en coupe d'une structure 350 formant le transistor 300.

Comme le transistor 200 décrit en relation avec la figure 2, le transistor 300 est un transistor à électron à haute mobilité, ou transistor HEMT. Le transistor 300, comprend une borne de grille, notée G en figure 3, une borne de source, notée S en figure 3, et une borne de drain, notée D en figure 3.

De plus, et à l'inverse du transistor 200 de la figure 2, le transistor 300 est un transistor HEMT à mode de enrichissement (enhancement mode), appelé ci-après transistor HEMT de type e-mode, ou transistor e-mode. Selon une autre appellation, le transistor 300 est un transistor HEMT de type normalement OFF (normally-OFF), ou transistor HEMT normalement OFF, ou transistor normalement OFF. Le schéma électrique du transistor 300 présenté en vue (A) est le schéma électrique qui sera utilisé dans toutes les figures suivantes pour représenter un transistor e-mode ou normalement OFF.

En pratique, le transistor 300 peut être obtenu par une structure 350 formée à partir d'une structure du type de la structure 100 décrite en relation avec la figure 1. Ainsi, la structure 350 comprend un substrat 351 (Si) en un matériau conducteur, comme du silicium, dont une face est recouverte par une couche 352 (GaN) en Nitrure de Gallium. La couche 352 en Nitrure de Gallium est partiellement recouverte par une couche 353 (AlGaN) en Nitrure d'Aluminium-Gallium. Une borne de connexion 354 forme la prise de contact de source S du transistor 300. La borne de connexion 354 est formée sur une portion de la couche 352 qui n'est pas recouverte de la couche 353. Une borne de connexion 355 forme la prise de contact de drain D du transistor 300. La borne de connexion 355 est formée sur une portion de la couche 352 qui n'est pas recouverte de la couche 353. Une borne de connexion 356 forme la prise de contact de grille G du transistor 300. La borne de connexion 356 est formée entre la couche 352 et la couche 353 et est disposée entre les plots de connexion 354 et 355. De plus, une portion du plot de connexion 354 recouvre la portion de la couche 353 recouvrant le plot de connexion 356 comme représenté en vue (B) de la figure 3.

Le fonctionnement du transistor 300 est le suivant. Lorsque la grille G du transistor 300 est laissé flottante ou qu'une tension négative est appliquée entre sa grille G et sa source S, le transistor 300 n'est pas conducteur ou non passant, d'où son appellation de transistor normalement OFF. Pour "ouvrir" le transistor 300, c'est-à-dire le rendre conducteur, une tension positive doit être appliquée entre sa grille G et sa source S.

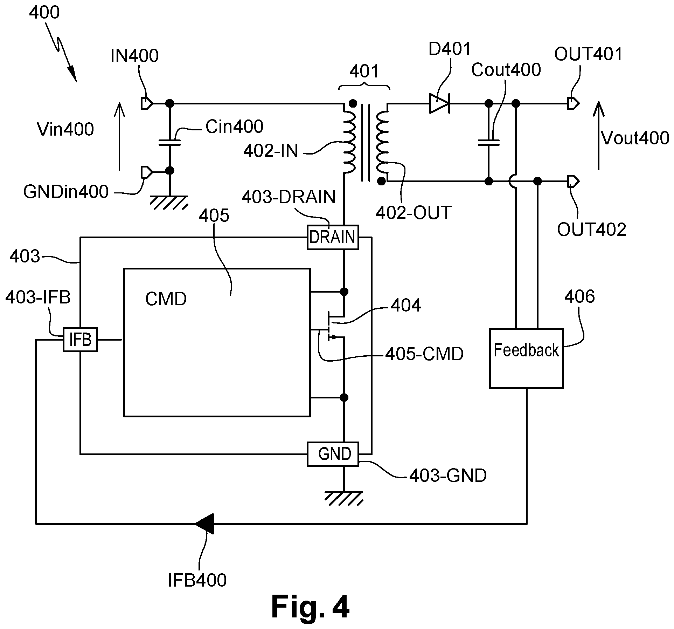

La figure 4 illustre, schématiquement et partiellement sous forme de blocs, une partie 400 d'un mode de réalisation simplifié d'une alimentation à découpage.

La partie 400, représentée en figure 4, comprend un premier noeud d'entrée IN400 et un deuxième noeud d'entrée GNDin400. La partie 400 reçoit entre les deux noeuds d'entrée IN400 et GNDin400 une tension d'entrée Vin400. Le noeud d'entrée GNDin400 reçoit, en outre, une première tension de référence, par exemple, une première masse.

La partie 400 comprend, entre les noeuds d'entrée IN400 et GNDin400 un condensateur Cin400. Selon un exemple, le condensateur Cin400 est un condensateur de filtrage.

La partie 400 comprend, en outre, un premier noeud de sortie OUT401 et un deuxième noeud de sortie OUT402. La partie 400 fournit, entre ces deux noeuds de sortie OUT401 et OUT402, une tension de sortie Vout400. Selon un exemple, le noeud de sortie OUT402 fournit, en outre, une deuxième tension de référence, par exemple, une deuxième masse, différente de la première tension de référence.

La partie 400 comprend, entre les noeuds de sortie OUT401 et OUT402, un condensateur Cout400. Selon un exemple, le condensateur Cout400 est un condensateur de filtrage.

La partie 400 comprend, en outre, un transformateur 401 comportant deux bobines 402-IN et 402-OUT. La bobine 402-IN est la bobine d'entrée du transformateur, dit autrement, une première borne de la bobine 402-IN est reliée, de préférence connectée, au premier noeud d'entrée IN400, et une deuxième borne de la bobine 402-IN est reliée, de préférence connectée, à une borne 403-DRAIN décrite plus en détails ci-après. La bobine 402-OUT est la bobine de sortie du transformateur, dit autrement, une première borne de la bobine 402-OUT est reliée au premier noeud de sortie OUT401, et une deuxième borne de la bobine 402-OUT est reliée, de préférence connectée, au deuxième noeud de sortie OUT402. En figure 4, les points de phase des bobines 402-IN et 402-OUT sont désignés par des points noirs.

Plus particulièrement, la première borne de la bobine 402-OUT est reliée au noeud de sortie OUT401 par l'intermédiaire d'une diode D401. Selon un exemple, l'anode de la diode D401 est reliée, de préférence connectée, à la première borne de la bobine 402-OUT, et la cathode de la diode D401 est reliée, de préférence connectée, au noeud de sortie OUT401. Selon un exemple, la diode D401 est une diode de rectification.

La partie 400 comprend, en outre, un commutateur de puissance 403 selon un mode de réalisation. Le commutateur de puissance comprend au moins trois bornes 403-DRAIN, 403-GND et 403-IFB. Comme dit précédemment, la borne 403-DRAIN est reliée, de préférence connectée, à la deuxième borne de la bobine 402-IN. La borne 403-GND reçoit la première tension de référence, c'est-à-dire la même tension de référence que le noeud d'entrée GNDin400. La borne 403-IFB reçoit un courant de retour IFB400 qui constitue une image de la tension de sortie Vout400.

Selon un mode de réalisation, le commutateur de puissance 403 est formé, au moins partiellement, dans et sur une structure du type de la structure 100 décrite en relation avec la figure 1. Le commutateur de puissance 403 comprend un interrupteur 404, ou transistor 404 et un circuit de commande 405 (CMD) dudit commutateur.

Le transistor 404 est un transistor de puissance de type HEMT à mode à enrichissement, ou transistor e-mode, ou transistor normalement OFF. Dans la suite de la description, le commutateur 404 est appelé transistor 404. Le transistor 404 comprend :

- une borne de drain reliée, de préférence connectée, à la borne 403-DRAIN ;
- une borne de source reliée, de préférence connectée, à la borne 403-GND ; et
- une borne de grille recevant une tension de commande 405-CMD fournie par le circuit de commande 405.

Selon un mode de réalisation, le transistor de puissance 404 est dimensionnée pour supporter une tension maximale de l'ordre de 650 V sa borne de drain et sa borne de source.

Selon un mode de réalisation, l'alimentation à découpage 400 fonctionne en modulation de largeur d'impulsion. Cette modulation est opérée par le circuit de commande 405 du commutateur de puissance 403.

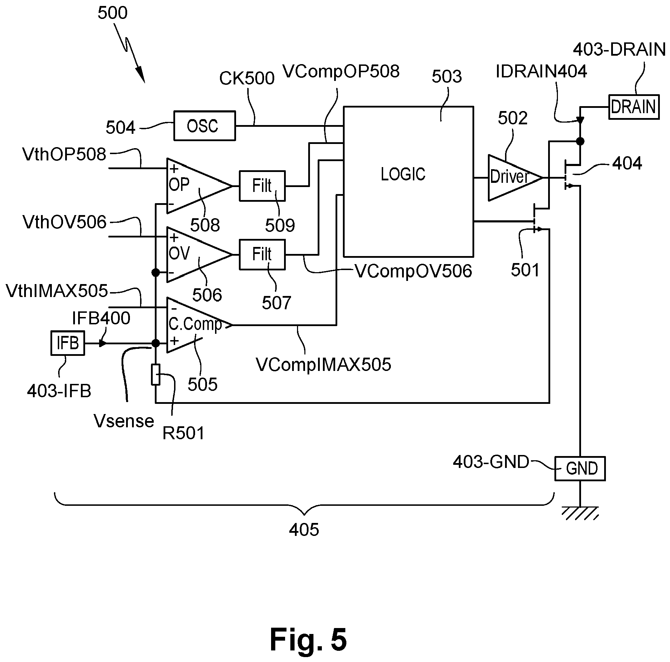

Le circuit de commande 405 reçoit comme courant de commande le courant IFB400. Autrement dit le circuit de commande est relié, de préférence connecté, à la borne 403-IFB. Le circuit de commande 405 est, en outre, relié, de préférence connecté, aux bornes 403-DRAIN et 403-GND. Le circuit de commande 405 et son fonctionnement sont décrits plus en détails en relation avec les figures 5 à 26.

La partie 400 comprend, en outre, un circuit de rétroaction 406 (Feedback) recevant, en entrée, la tension de sortie Vout400, et fournissant, en sortie, le courant de retour IFB400.

L'alimentation à découpage décrite en relation avec la figure 4 est une alimentation à découpage de type "Hors ligne" ou "OFF-line" qui est destinée à recevoir en entrée, c'est-à-dire entre les noeuds IN400 et GNDin400, une tension d'entrée provenant directement du réseau électronique ménager. Cette tension d'entrée peut être, selon un exemple, redressée et/ou filtrée, mais son amplitude n'est pas abaissée. Ainsi la tension d'entrée Vin400 peut avoir une amplitude très élevée, c'est-à-dire, par exemple, inférieure à 450 V..

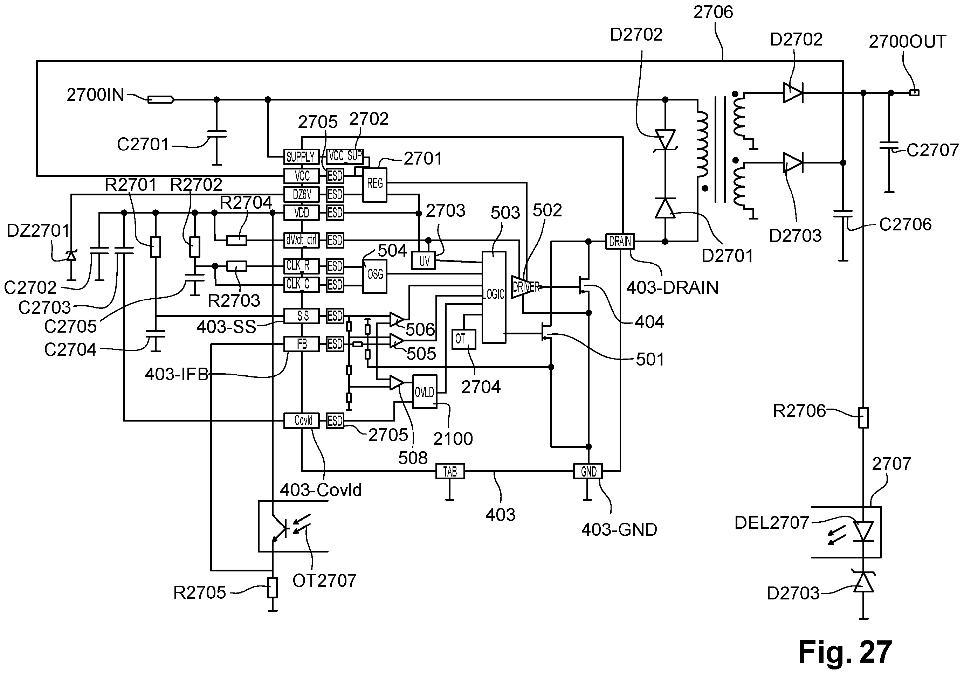

Un mode de réalisation plus détaillé d'une alimentation à découpage du type de l'alimentation à découpage comprenant la partie 400 est décrit en détail en relation avec la figure 27.

La figure 5 représente, schématiquement et sous forme de blocs, un commutateur de puissance 500 du type du commutateur de puissance 403 décrit en relation avec la figure 4.

Selon un mode de réalisation, le commutateur de puissance 500 est un composant monolithique formé en partie, de préférence en totalité, dans et sur une structure du type de la structure 100 décrite en relation avec la figure 1.

Selon un mode de réalisation préféré, le commutateur de puissance 500 est formé en totalité sur une structure monolithique du type de la structure 100 de la figure 1. En effet, avoir un transistor de puissance et son circuit de commande sur une même structure, c'est-à-dire sur un même substrat ou une même puce, permet d'éviter l'utilisation de moyens de conduction, comme des fils, qui apportent des phénomènes parasites, dues par exemple à la longueur des fils.

Comme décrit précédemment, le commutateur de puissance 500 comporte le transistor 404 de type e-mode, le circuit de commande 405, et les bornes 403-DRAIN, 403-GND et 403-IFB. Le courant au niveau du drain du transistor 404 est noté IDRAIN404. La tension entre la borne 403-IFB et la borne 403-GND est noté Vsense500.

Le circuit de commande 405 est, plus particulièrement, un circuit de modulation de largeur d'impulsion permettant de commander l'ouverture et la fermeture du transistor 404. Plus particulièrement, le circuit de commande 405 permet de fournir une tension de commande périodique ou pseudopériodique à la grille du transistor 404.

Le circuit de commande 405 comprend un transistor 501 de type e-mode et une résistance R501. Le transistor 501 et la résistance R501 sont reliés en série, et relient la borne 403-DRAIN à la borne 403-IFB. Plus précisément, le transistor 501 comprend une borne de drain reliée, de préférence connectée, à la borne 403-DRAIN, et une borne de source reliée, de préférence connectée, à une première borne de la résistance R501. Une deuxième borne de la résistance R501 est reliée, de préférence connectée, à la borne 403-IFB. La borne de grille du transistor 501 est reliée, de préférence connectée, à une borne de sortie d'un circuit logique 503 (LOGIC) décrit ci-après.

Le circuit de commande 405 comprend, en outre, un circuit de pilotage 502 (DRIVER), ou circuit de commande rapprochée 502, adapté à fournir un potentiel de commande à la grille du transistor 404. Le circuit de pilotage 502 reçoit au moins un potentiel de commande de la part du circuit logique 503 décrit ci-après. Une personne du métier saura mettre en oeuvre le circuit de pilotage 502. A titre d'exemple, des exemples de réalisation d'un tel circuit de pilotage 502 sont données dans la demande de brevet français référencée FR2210660.

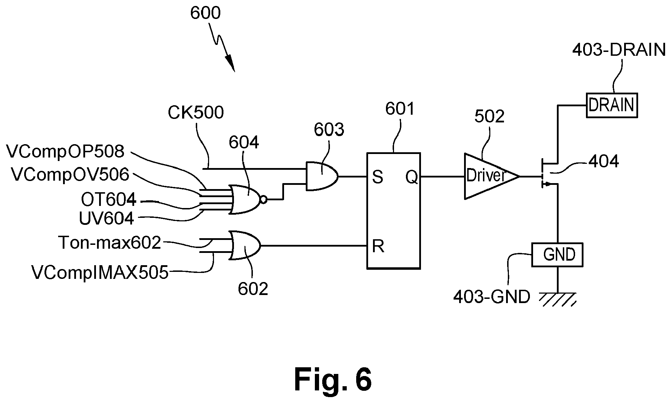

Le circuit de commande 405 comprend, en outre, le circuit logique 503 (LOGIC) adapté à commander le circuit de pilotage 502 et le transistor 501. Le circuit logique 503 peut être composé de portes logiques décrites plus en détails en relation avec la figure 6, qui permettent de commander, par l'intermédiaire du circuit de pilotage 502, le transistor de puissance 404. Pour cela le circuit logique 503 reçoit, au moins, différentes tensions de comparaison VCompIMAX505, VcompOV506, et VCompOP508, et une tension d'horloge CK500.

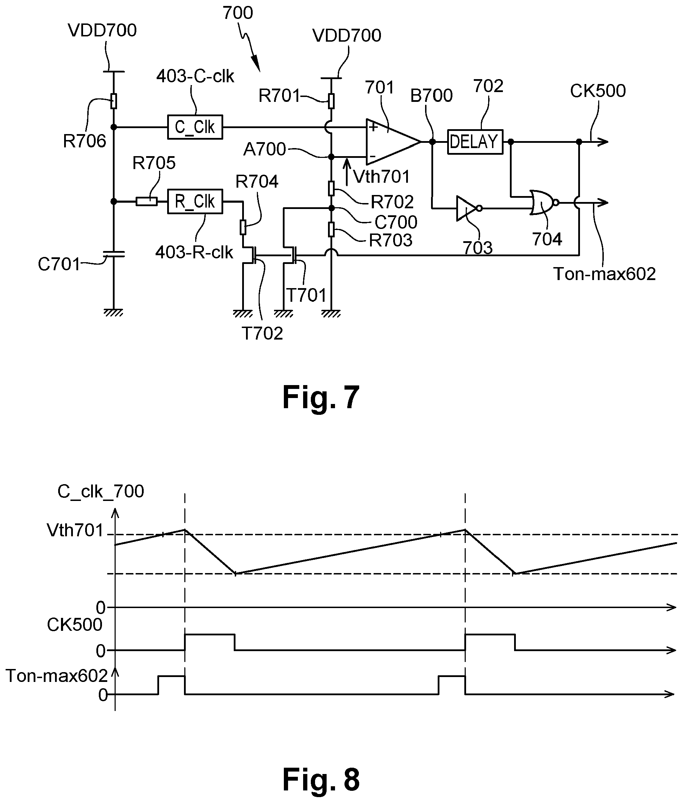

Le circuit de commande 405 comprend, en outre, un circuit oscillant 504 (OSC) adapté à fournir la tension d'horloge CK500. Un exemple détaillé de circuit oscillant 504 est décrit en relation avec les figures 7 et 8.

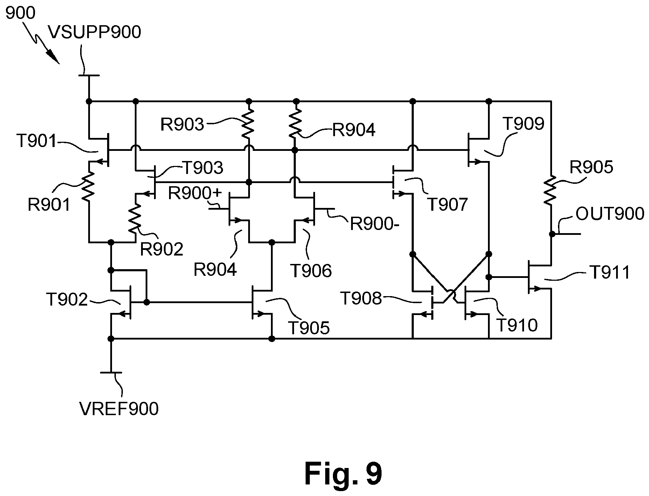

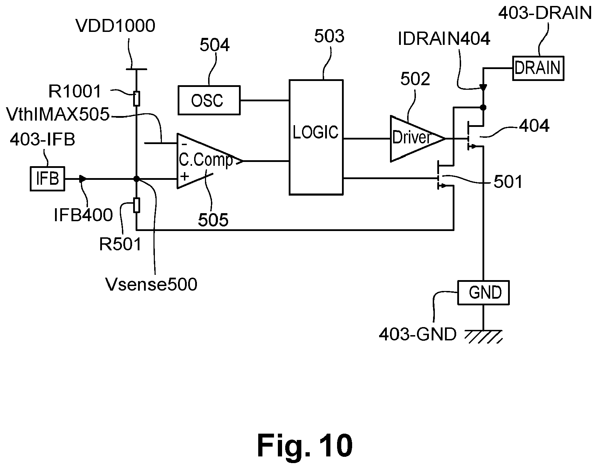

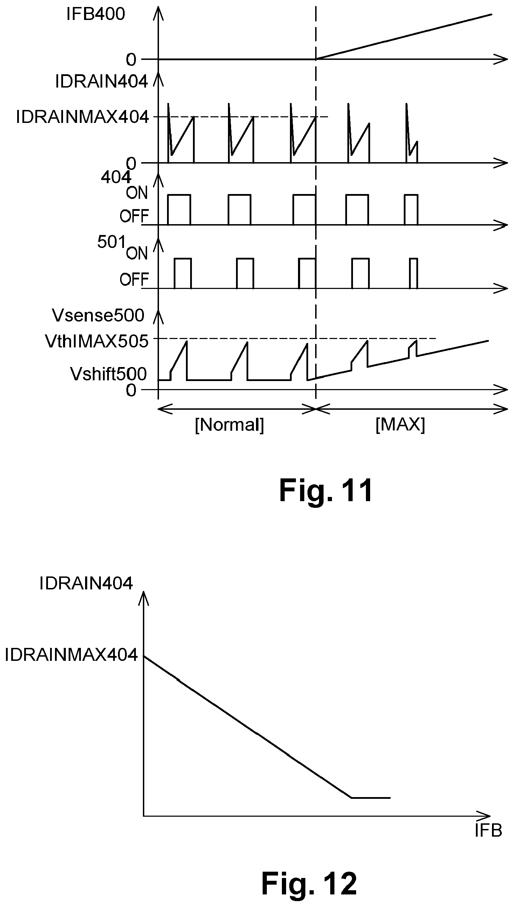

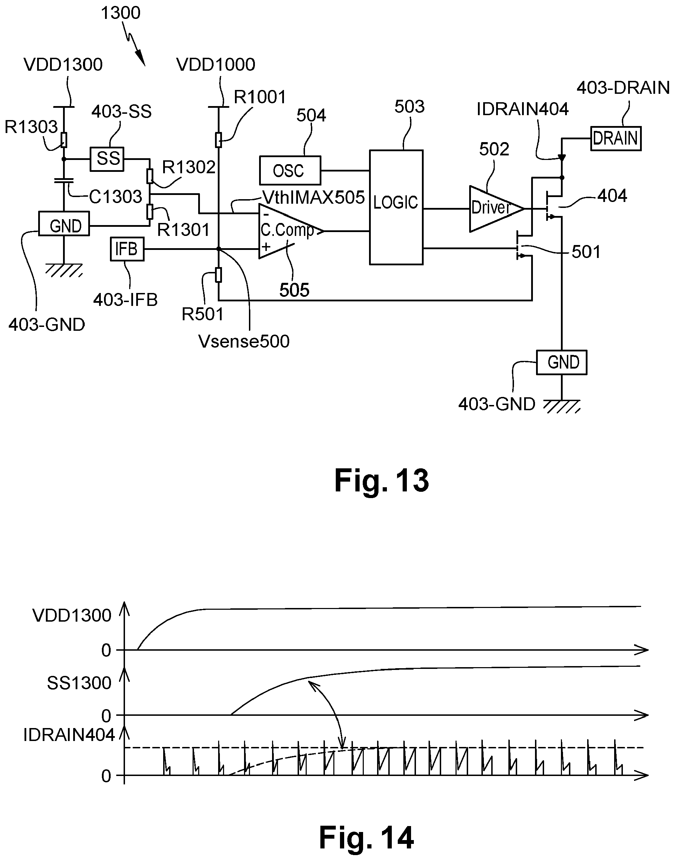

Le circuit de commande 405 comprend, en outre, un circuit comparateur 505 (C Comp) comprenant une entrée (+) reliée à la borne 403-IFB, et une entrée inverseuse (-) recevant une tension de seuil VthIMAX505. Le circuit comparateur 505 fournit, en sortie, la tension de comparaison VCompIMAX505. Le circuit comparateur 505 permet de vérifier si le courant de sortie du commutateur de puissance 500 ne dépasse pas une valeur maximale. Un exemple de réalisation d'un circuit comparateur est décrit en relation avec la figure 9. Des exemples de réalisation du circuit comparateur 505 sont décrits en relation avec les figures 10 et 13, et leurs fonctionnements sont décrits en relation avec les figures 11, 12 et 14.

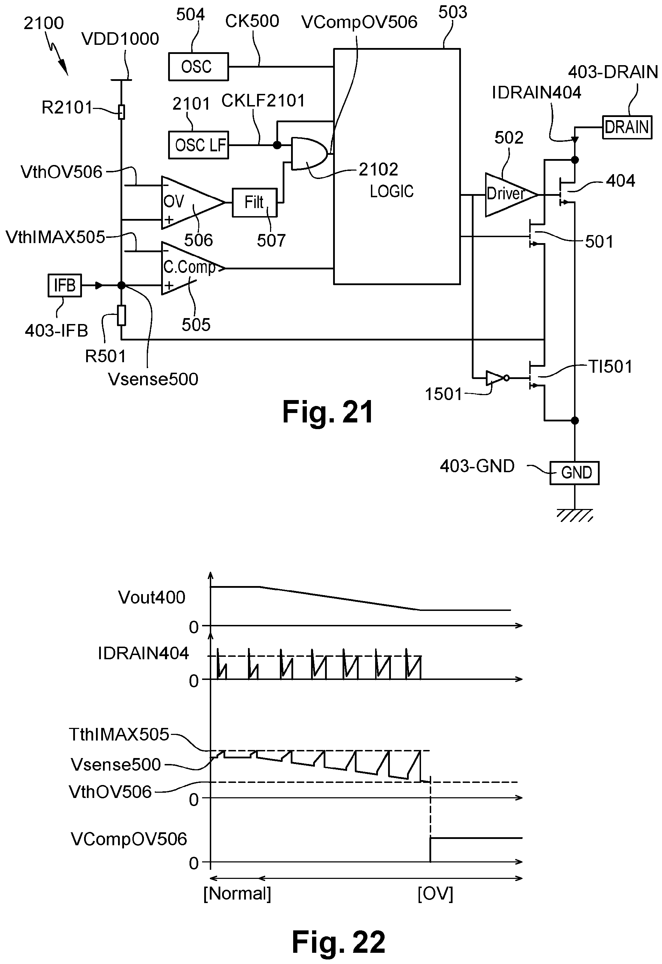

Le circuit de commande 405 comprend, en outre, un circuit comparateur 506 (OV) et un circuit de filtrage 507 (Filt.). Le circuit comparateur 506 comprend une entrée (+) reliée à la borne 403-IFB, et une entrée inverseuse (-) recevant une tension de seuil VthOV506. La sortie du circuit comparateur 506 est reliée, de préférence connectée, à une entrée du circuit de filtrage 507. Le circuit de filtrage fournit, en sortie, la tension de comparaison VCompOV506. Le circuit comparateur 506 et le circuit de filtrage 507 permettent de vérifier si la sortie du commutateur de puissance 500 ne présente pas de court-circuit. Le fonctionnement de ces circuits est décrit en relation avec les figures 21 à 24.

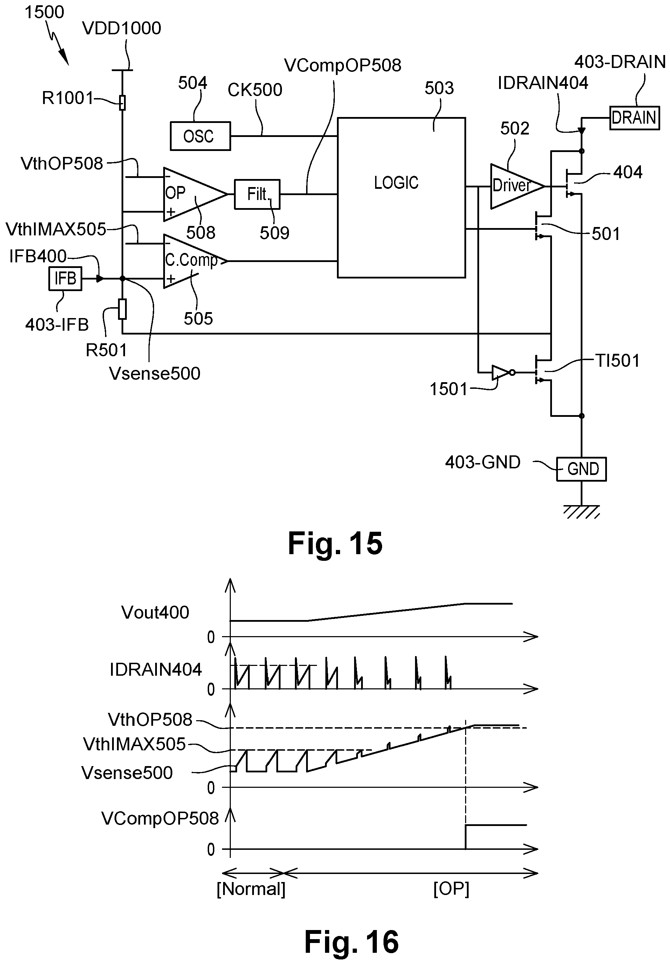

Le circuit de commande 405 comprend, en outre, un circuit comparateur 508 (OP) et un circuit de filtrage 509 (Filt.). Le circuit comparateur 508 comprend une entrée (+) reliée à la borne 403-IFB, et une entrée inverseuse (-) recevant une tension de seuil VthOP508. La sortie du circuit comparateur 508 est reliée, de préférence connectée, à une entrée du circuit de filtrage 509. Le circuit de filtrage fournit, en sortie, la tension de comparaison VCompOP508. Le circuit comparateur 508 et le circuit de filtrage 509 permettent de vérifier si la sortie du commutateur de puissance 500 n'est pas un circuit ouvert. Le fonctionnement de ces circuits est décrit en relation avec les figures 15 à 20.

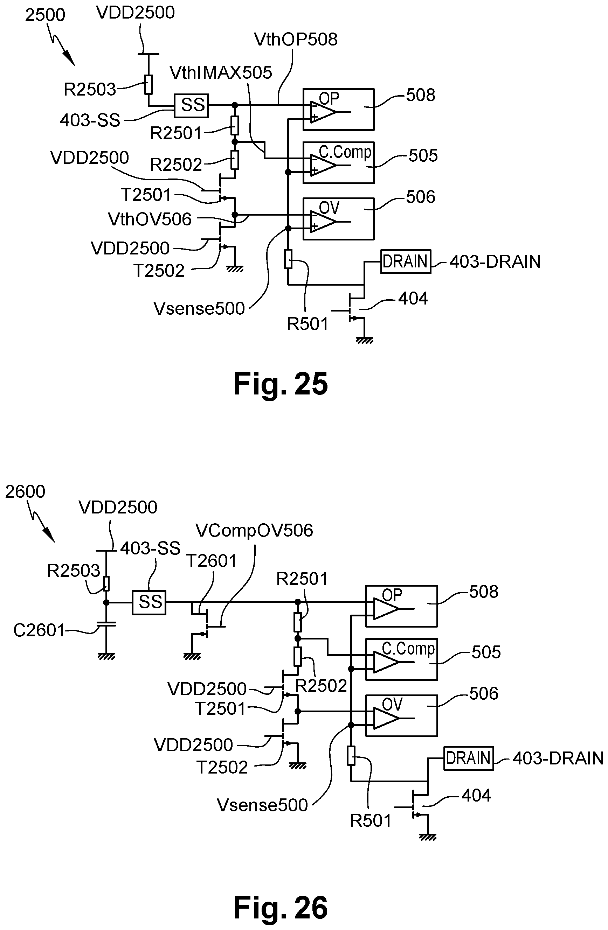

Des circuits fournissant les tensions de seuil VthIMAX505, VthOV506 et VthOP508 sont décrits en relation avec les figures 25 et 26.

La figure 6 représente un exemple de réalisation d'un circuit logique 600 du type du circuit logique 503 décrit en relation avec la figure 5. En figure 6, sont, en outre, représentés le circuit de pilotage 502 (DRIVER), le transistor de puissance 404, et les bornes 403-DRAIN (DRAIN) et 403-GND (GND), tous décrits précédemment.

Le circuit 600 comprend une bascule 601 de type RS. La bascule 601 comprend trois bornes parmi lesquelles une borne d'initialisation (set) S, une borne de réinitialisation (reset) R et une borne de sortie Q. Lorsqu'un front montant est appliqué à la borne d'initialisation S, la borne de sortie Q fournit un signal ayant un état haut, et lorsqu'une front montant est appliqué à la borne de réinitialisation R, la borne de sortie Q fournit un signal ayant état bas. On appelle un signal ayant un état haut, un signal dont la valeur de l'amplitude correspond à un état binaire haut, c'est-à-dire un état binaire égal à "1". De façon similaire, on appelle un signal ayant un état bas, un signal dont la valeur de l'amplitude correspond à un état binaire bas, c'est-à-dire un état binaire égal à "0".

La borne de sortie Q de la bascule 601 est reliée, de préférence connectée à une entrée du circuit de pilotage 502 du transistor de puissance 404.

Le circuit 600 comprend, en outre, une porte logique 602 de type OU (OR) ayant deux entrées et une sortie. La sortie de la porte logique 602 est reliée, de préférence connectée, à la borne R de la bascule 601. Une première entrée de la porte logique 602 reçoit la tension VCompIMAX505 de sortie du circuit comparateur de courant 505 décrit en relation avec la figure 5. Une deuxième entrée de la porte logique 602 reçoit une tension de surveillance Ton-max permettant de vérifier qu'une durée du cycle de conduction du transistor de puissance 404 ne dépasse pas une durée limite. Selon un exemple, la tension Ton-max602 est fournie par le circuit oscillant 504 décrit en relation avec la figure 5.

Le circuit 600 comprend, en outre, une porte logique 603 de type ET (AND) comprenant deux entrées et une sortie. La sortie de la porte logique 603 est reliée, de préférence connectée, à la borne d'initialisation de la bascule 601. Une première borne de la porte logique 603 reçoit la tension d'horloge CK500 fournie par le circuit oscillant 504 décrit en relation avec la figure 5.

Le circuit 600 comprend, en outre, une porte logique 604 de type NON-OU (NOR) comprenant au moins deux entrées, et une sortie. La sortie de la porte logique 604 est reliée, de préférence connectée, à la deuxième entrée de la porte logique 603. Une première entrée de la porte logique 604 reçoit la tension VCompOP508 fournit par le circuit de filtrage 509 décrit en relation avec la figure 5. Une deuxième entrée de la porte logique 604 reçoit la tension VCompOV506 fournit par le circuit de filtrage 507 décrit en relation avec la figure 5.

De plus, de manière optionnelle, la porte logique 604 peut comprendre des entrées supplémentaires recevant d'autres tensions comme une tension OT604 de détection d'une surchauffe, et/ou une tension UV604 de détection d'une tension d'alimentation du circuit de commande 403 du transistor de puissance 404 trop faible.

Ainsi, les valeurs des tensions CK500, VCompOP508, VcompOV506, VCompIMAX505 et Ton-max602, et, de façon optionnelle les valeurs des tensions OT604 et UV604 ont la capacité de démarrer et/ou d'arrêter un cycle de conduction du transistor de puissance 404.

La figure 7 représente un mode de réalisation d'un circuit oscillant 700 du type du circuit oscillant 504 décrit en relation avec la figure 5.

Le circuit oscillant 700 comprend un circuit comparateur 701 comprenant deux entrées et une sortie. Une première entrée (+) du circuit comparateur 701 est reliée, de préférence connectée, à une borne 403_c_clk constituant une borne du commutateur de puissance 403 décrit en relation avec la figure 4. Une deuxième entrée (-) du circuit comparateur 701 est une entrée inverseuse, et est reliée, de préférence connectée, à un noeud A700 d'application d'une tension de seuil Vth701 du circuit comparateur. La sortie du circuit comparateur 701 est reliée, de préférence connectée, à un noeud B700. Un exemple de réalisation du circuit comparateur 701 est décrit en relation avec la figure 9.

Le circuit oscillant 700 comprend, en outre, un élément à retard 702 (DELAY). L'élément à retard 702 comprend une entrée reliée, de préférence connectée au noeud B700 et une sortie fournissant la tension d'horloge CK500.

Le circuit oscillant 700 comprend, en outre, une porte logique 703 de type inverseuse et une porte logique 704 de type NON-OU (NOR). Une entrée de la porte logique 703 est reliée, de préférence connectée, au noeud B700. Une sortie de la porte logique 703 est reliée, de préférence connectée, à une première entrée de la porte logique 704. Une deuxième entrée de la porte logique 704 est reliée, de préférence connectée, à la sortie de l'élément à retard 702. Une sortie de la porte logique 704 fournit la tension Ton-max602 décrite en relation avec la figure 6.

Le circuit oscillant 700 comprend, en outre, un pont diviseur de tension permettant de générer la tension de seuil Vth701. Le pont diviseur de tension comporte trois résistances R701, R702 et R703. Une première borne de la résistance R701 est reliée, de préférence connectée, à un noeud recevant une tension d'alimentation VDD700, et une deuxième borne de la résistance R701 est reliée, de préférence connectée, à l'entrée inverseuse du circuit comparateur 701. Une première borne de la résistance R702 est reliée, de préférence connectée, à l'entrée inverseuse du circuit comparateur 701, et une deuxième borne de la résistance R702 est reliée, de préférence connectée, à un noeud C700. Une première borne de la résistance R703 est reliée, de préférence connectée, au noeud C700, et une deuxième borne de la résistance R703 est reliée, de préférence connectée, à la borne 403-700. En figure 7, la borne 403-700 est représentée par le symbole de la masse.

Le circuit oscillant 700 comprend, en outre, un transistor T701 de type e-mode comprenant une première borne de conduction reliée, de préférence connectée, au noeud C700, et une deuxième borne de conduction reliée, de préférence connectée, à la borne 403-GND. La grille du transistor T701 est reliée de préférence à la sortie de l'élément à retard 702.

Le circuit oscillant 700 comprend, en outre, un transistor T702 de type e-mode et une résistance R704. Une première borne de conduction du transistor T702 est reliée, de préférence connectée, à une première borne de la résistance R704, et une deuxième borne de conduction du transistor T702 est reliée, de préférence connectée, à la borne 403-GND. Une deuxième borne de conduction de la résistance R704 est reliée, de préférence connectée, à une borne 403_R_clk constituant une autre borne du commutateur de puissance 403 décrit en relation avec la figure 4.

Le circuit oscillant 700 comprend, en outre et pour finir, deux résistances R705 et R706 et un condensateur C701. Une première borne de la résistance R705 est reliée, de préférence connectée, à la borne 403_R_clk, et une deuxième borne de la résistance R705 est reliée, de préférence connectée, à la borne 403_c_clk. Une première borne de la résistance R706 est reliée, de préférence connectée, à la borne 403_R_clk, et une deuxième borne de la résistance R705 est reliée, de préférence connectée, au noeud recevant la tension d'alimentation VDD700. Une première borne du condensateur C701 est reliée, de préférence connectée, à la borne 403_c_clk, et une deuxième borne du condensateur C701 est reliée, de préférence connectée, à la borne 403-GND.

Le fonctionnement du circuit oscillant 700 est décrit en relation avec la figure 8.

La figure 8 représente des chronogrammes illustrant le fonctionnement du circuit oscillant 700 décrit en relation avec la figure 7.

Plus particulièrement, la figure 8 comprend les chronogrammes suivants :

- un chronogramme représentant l'évolution temporelle de la tension C_clk_700 égale à la différence de potentiels entre la borne 403-c_clk et la borne 403-GND ;
- un chronogramme représentant l'évolution temporelle de la tension d'horloge CK500 ; et
- un chronogramme représentant l'évolution temporelle de la tension Ton_max505.

Le circuit de type RC série formé par le condensateur C701 et la résistance R706 est alimenté par la tension d'alimentation VDD700. La tension C_clk_700 est une tension périodique qui est comparée en continue, par le circuit comparateur 701 à la tension seuil Vth701.

La tension d'horloge CK500 est une tension périodique présentant des impulsions positives à intervalles réguliers. La période de la tension d'horloge CK500 est fixée par la durée de charge du condensateur C701. La durée des impulsions positives de la tension d'horloge CK500 est fixée par la durée de la décharge du condensateur C701 dans les résistances R706 et R705.

La tension Ton_max505 est une tension périodique présentant des impulsions positives à intervalles réguliers. La période de la tension Ton_max505 est égale à la période la tension d'horloge CK500. Une période de la tension Ton_max505 démarre, à un état bas, à l'instant où la tension d'horloge CK500 présente un front montant, c'est-à-dire à partir du moment où une impulsion positive de la tension d'horloge démarre. La tension Ton_max505 présente un état haut à partir d'une durée fixée par à l'élément à retard 702. La période de la tension Ton_max505 se termine par un front descendant au moment où la tension d'horloge CK500 présente un nouveau front montant.

La figure 9 représente un exemple de réalisation d'un circuit comparateur 900 pouvant être utilisé dans le mode de réalisation du commutateur de puissance 400 décrit en relation avec la figure 4.

Le circuit comparateur 900 comprend deux noeuds d'alimentation VSUPP900 et VREF900, deux noeuds d'entrée N900+ et N900- et un noeud de sortie OUT900. Le noeud d'alimentation VSUPP900 reçoit une tension supérieure à la tension reçue par le noeud VREF900, par exemple, le noeud d'alimentation VSUPP reçoit une tension de l'ordre de 6 V et le noeud VREF900 reçoit une tension de l'ordre de 0 V. Les noeuds d'entrée N900+ et N900- reçoivent les tensions à comparer. Le noeud OUT900 fournit la tension représentant le résultat de la comparaison des tensions reçues par les noeuds N900+ et N900-.

Le circuit 900 comprend, entre les noeuds VSUPP900 et VREF900, et sur une première branche, un transistor T901 de type d-mode, une résistance R901, et un transistor T902 de type d-mode. Le drain du transistor T901 est reliée, de préférence connectée, au noeud VSUPP900, et la source du transistor T901 est reliée, de préférence connectée, à une première borne de la résistance R901. La deuxième borne de la résistance R901 est reliée, de préférence connectée, au drain et à la grille du transistor T902. La source du transistor T902 est reliée, de préférence connectée, au noeud VREF900.

Le circuit 900 comprend, en outre, entre le noeud VSUPP900 et le noeud milieu entre la résistance R901 et le transistor T902, et sur une deuxième branche, un transistor T903 de type d-mode et une résistance R902. Le drain du transistor T903 est relié, de préférence connecté, au noeud VSUPP900, et la source du transistor T903 est reliée, de préférence connectée, à une première borne de la résistance R902. La deuxième borne de la résistance R902 est reliée, de préférence connectée, au noeud milieu entre la résistance R901 et le transistor T902. Selon une variante de réalisation, les transistors T901 et T902 peuvent être des transistors de type e-mode.

Le circuit 900 comprend, entre les noeuds VSUPP900 et VREF900, et sur une troisième branche, une résistance R903, un transistor T904 de type d-mode, et un transistor T905 de type d-mode. Une première borne de la résistance R903 est reliée, de préférence connectée, au noeud VSUPP900, et deuxième borne de la résistance R903 est reliée, de préférence connectée, au drain du transistor T904 et à la grille du transistor T903. La source du transistor T904 est reliée, de préférence connectée, au drain du transistor T905. La source du transistor T905 est reliée, de préférence connectée, au noeud VREF900. La grille du transistor T904 est reliée, de préférence connectée, au noeud N900+.

Le circuit 900 comprend, entre les noeuds VSUPP900 et VREF900, et sur une quatrième branche, une résistance R904, un transistor T906 de type d-mode, et le transistor T905. Une première borne de la résistance R904 est reliée, de préférence connectée, au noeud VSUPP900, et deuxième borne de la résistance R904 est reliée, de préférence connectée, au drain du transistor T906 et à la grille du transistor T901. La source du transistor T906 est reliée, de préférence connectée, au drain du transistor T905. La grille du transistor T906 est reliée, de préférence connectée, au noeud N900-.

Le circuit 900 comprend, entre les noeuds VSUPP900 et VREF900, et sur une cinquième branche, un transistor T907 de type e-mode, et un transistor T908 de type e-mode. Le drain du transistor T907 est relié, de préférence connecté, au noeud VSUPP900, et la source du transistor T907 est reliée, de préférence connectée, au drain du transistor T908. La source du transistor T908 est reliée, de préférence connectée, au noeud VREF900. La grille du transistor T907 est reliée, de préférence connectée, à la grille du transistor T903.

Le circuit 900 comprend, entre les noeuds VSUPP900 et VREF900, et sur une sixième branche, un transistor T909 de type d-mode, et un transistor T910 de type d-mode. Le drain du transistor T909 est relié, de préférence connecté, au noeud VSUPP900, et la source du transistor T909 est reliée, de préférence connectée, au drain du transistor T910. La source du transistor T910 est reliée, de préférence connectée, au noeud VREF900. La grille du transistor T909 est reliée, de préférence connectée, à la grille du transistor T901.

Selon un premier exemple, illustré en figure 9, la grille du transistor T908 est reliée, de préférence connectée, au drain du transistor T910, et la grille du transistor T910 est reliée, de préférence connectée, au drain du transistor T908.

Selon un deuxième exemple, non illustré en figure 9, les grilles des transistors T908 et T910 sont reliées, de préférence connectées, entre elles et au drain du transistor T908.

Le circuit 900 comprend, entre les noeuds VSUPP900 et VREF900, et sur une septième, et dernière, branche, une résistance R905 et transistor T911 de type d-mode. Une première borne de la résistance R905 est reliée, de préférence connectée, au noeud VSUPP900, et une deuxième borne de la résistance R905 est reliée, de préférence connectée, au noeud de sortie OUT900. Le drain du transistor T911 est relié, de préférence connecté, au noeud OUT900, et la source du transistor T911 est reliée, de préférence connectée, au noeud VREF900. La grille du transistor T911 est reliée, de préférence connectée, au drain du transistor T910.

Les transistors T904 et T905 sont des transistors d'entrée différentielles. Les résistances R901 et R902 sont des résistances de polarisation. Les transistors T901, T902, T903 et T905 sont des transistors de polarisation. Les transistors T907 et T909 sont des transistors suiveurs de tension. Les transistors T908 et T910 sont des comparateurs de courants. La septième branche est une branche de sortie.

Le circuit comparateur 900 fonctionne de la façon suivante. Lorsque la tension de grille du transistor T906 devient supérieure à la tension de grille du transistor T904, alors la tension de grille du transistor T909 devient inférieure à la tension de grille du transistor T907, ce qui entraine que la tension de grille du transistor T911 devient inférieure à la tension de seuil du transistor T911. La tension de sortie VOUT900 est alors reliée à la tension VSUPP900.

La figure 10 représente un premier mode de réalisation d'un circuit 1000 comparateur de courant du mode de réalisation de la figure 5.

Comme expliqué en relation avec la figure 5, le circuit de commande 405 du transistor de puissance 404 comprend le circuit comparateur 505. Le circuit 1000 permet de vérifier si le courant de sortie fournit par l'alimentation à découpage comprenant le commutateur de puissance 403 ne dépasse pas une valeur seuil. Le courant de rétroaction IFB400 décrit en relation avec la figure 4 est une image du courant de sortie de l'alimentation à découpage et permet de réaliser cette comparaison.

Une absence de charge se traduit par une tension de sortie dépassant une valeur limite, aussi appelée surcharge de tension en sortie. Une telle augmentation de la tension de sortie se traduit par une augmentation du courant de rétroaction IFB400.

Le circuit comparateur 505 (C Comp) comprend une entrée (+) reliée à borne 403-IFB, et une entrée inverseuse (-) recevant une tension de seuil VthIMAX505. Le circuit comparateur 505 fournit, en sortie, la tension de comparaison VCompIMAX505 au circuit logique 503.

La borne 403-IFB est, en outre, reliée à un nœud recevant une tension d'alimentation VDD1000 par l'intermédiaire d'une résistance R1001.

Le fonctionnement de cette comparaison de courant est décrite plus en détails en relation avec les figures 11 et 12.

La figure 11 représente des chronogrammes illustrant le fonctionnement de la comparaison réalisée par le circuit comparateur 505 de la figure 10.

La figure 11 comprend, plus particulièrement, les chronogrammes suivants :

- un chronogramme représentant l'évolution temporelle du courant IFB400 ;
- un chronogramme représentant l'évolution du courant IDRAIN404 ;
- un chronogramme représentant l'état, ouvert (ON) ou fermé (OFF), du transistor 404 ;
- un chronogramme représentant l'état, ouvert (ON) ou fermé (OFF) du transistor 501 ; et
- un chronogramme représente l'évolution temporelle d'une tension Vsense500 représentant la tension entre la borne (+) d'entrée non inverseuse du circuit comparateur 505 et la borne 403-GND.

Comme dit précédemment, le transistor de puissance 404 est piloté par le circuit de pilotage 502 qui reçoit lui-même une tension de commande la part du circuit logique 503. Lors de son fonctionnement le transistor de puissance 404 présente une alternance d'états ouverts et fermés dont la fréquence est définie par la fréquence de la tension d'horloge CK500. Plus particulièrement, à chaque front montant de la tension d'horloge CK500, le transistor de puissance 404 présente un état fermé, ou état passant, dont la durée minimale est définie par la durée d'un état haut de la tension d'horloge CK500. Le courant IDRAIN404 au niveau du drain du transistor 404 présente un pic positif à l'ouverture du transistor puis augmente de façon linéaire comme illustré.

Le transistor 501 est commandé par les fronts descendants de la tension d'horloge CK500.

Pendant une phase d'ouverture, ou une phase de conduction, du transistor de puissance 404, le courant de rétroaction IFB est comparé à un courant seuil IFBMAX. Pour réaliser cette comparaison, la tension Vsens500 est comparée à la tension VthIMAX505. La tension VthIMAX505 est obtenue grâce à un circuit décrit ci-après en relation avec les figures 25 et 26. De plus, pour optimiser la comparaison la tension Vsense500 présente une composante Vshift505 dépendante des résistances R501 et R1001 et de la tension VDD1000 qui représente la tension de décalage interne du circuit comparateur 505.

La figure 11 présente deux cas, un cas [Normal] pendant lequel le courant de de rétroaction IFB400 reste constant à une valeur basse, par exemple zéro, et un cas [Max] pendant lequel le courant de rétroaction IFB400 présente une augmentation.

Lorsque le courant de rétroaction IFB400 augmente, la tension Vsense500 augmente également, et aussi pendant un état ouvert, ou un état de non-conduction du transistor 404. Cette augmentation est détectée par le circuit comparateur 505, puis prise en compte par le circuit logique 503, qui reçoit la tension VthIMAX505, et qui écourte la ou les phases de conduction suivantes du transistor 404.

La figure 12 représente une courbe illustrant l'évolution du courant de drain IDRAIN404 en fonction du courant de rétroaction IFB400 pendant le début d'une phase de conduction.

Le courant de drain IDRAIN404 est donné par la formule mathématique suivante :

[Math 1]

$$IDRAIN404 = -IFB400 * \frac{R501 + Rdson404}{Rdson404} - VDD1000 * \frac{R501 + Rdson404}{Rdson404 * R1001}$$
$$+ VthIMAX505 * \frac{R501 + R1001 + Rdson404}{Rdson404 * R1001}$$

dans lequel Rdson404 représente la résistance interne du transistor de puissance 404 lorsqu'il est conducteur.

La figure 13 représente un deuxième mode de réalisation d'un circuit 1300 comparateur de courant du mode de réalisation de la figure 5 du type du circuit 1000 décrit en relation avec la figure 10.

Le circuit 1300 présente des éléments communs avec le circuit 1000. Ces éléments communs ne sont pas décrits en détails de nouveau ici, seules les différences entre les circuits 1000 et 1300 sont mises en exergue.

Comme le circuit 1000, le circuit 1300 comprend le circuit comparateur 505 et les résistance R501 et R1001. Le circuit 1300 comprend, en outre, un agencement de composants permettant de fixer la valeur de la tension VthIMAX505 et permettant de réaliser un démarrage progressif.

Le circuit 1300 comprend donc, en outre, deux résistances R1301 et R1302. Une première borne de la résistance R1301 est reliée, de préférence connectée, à la borne 403-GND, et une deuxième borne de la résistance R1301 est reliée, de préférence connectée, à la borne d'entrée inverseuse du circuit comparateur 505. Une première borne de la résistance R1302 est reliée, de préférence connectée, à la borne d'entrée inverseuse du circuit comparateur 505, et une deuxième borne de la résistance R1301 est reliée, de préférence connectée, à une borne 403-SS pouvant constituer une borne du commutateur de puissance 403. Les résistances R1301 et R1302 permettent de fixer la valeur de la tension VthIMAX505.

Le circuit 1300 comprend, en outre, une résistance R1303 et un condensateur C1301. Une première borne de la résistance R1303 est reliée, de préférence connectée, à un noeud recevant une tension d'alimentation VDD1300, et une deuxième borne de la résistance R1301 est reliée, de préférence connectée, à la borne 403-SS. Selon un exemple, la tension d'alimentation VDD1300 est la même que la tension d'alimentation VDD1000. Une première borne du condensateur C1301 est reliée, de préférence connectée, à la borne 403-GND, et une deuxième borne du condensateur C1301 est reliée, de préférence connectée, à une borne 403-GND.

Le fonctionnement du circuit 1300 est décrit en relation avec la figure 14.

La figure 14 représente des chronogrammes illustrant le fonctionnement du circuit 1300 comparateur de courant de la figure 13. La figure 14 illustre, plus particulièrement, un mode de fonctionnement à démarrage lent du circuit comparateur dans lequel le seuil de déclenchement du circuit comparateur est augmenté lentement.

La figure 14 représente, plus particulièrement, les chronogrammes suivants :

- un chronogramme représentant l'évolution temporelle de la tension d'alimentation VDD1300 ;
- un chronogramme représentant l'évolution temporelle d'une tension SS1300 prise entre la borne 403-SS et la borne 403-GND ; et
- un chronogramme représentant l'évolution temporelle du courant IDRAIN404.

La tension SS1300 est une tension de commande de démarrage du commutateur de puissance 403. Lorsque le commutateur de puissance 403 démarre, ses circuits d'alimentation fournissant la tension VDD1300 démarre, et la tension VDD1300 croit petit à petit, par l'intermédiaire du condensateur 1303. Lorsque la tension SS1300 croit à son tour, et permet de limiter la valeur de la tension VthIMAX505 au démarrage et donc de limiter la valeur du courant IDRAIN404 le temps du démarrage.

La figure 15 représente un mode de réalisation d'un circuit de détection 1500 d'une charge de sortie ouverte du mode de réalisation de la figure 5.

Comme expliqué en relation avec la figure 5, le circuit de commande 405 du transistor de puissance 404 comprend le circuit comparateur 508 et le circuit de filtrage 509 permettant tous deux de détecter une absence de charge en sortie de l'alimentation à découpage comprenant le commutateur de puissance 403. Une absence de charge se traduit par une tension de sortie dépassant une valeur limite. Comme dit précédemment, l'image de la tension de sortie de l'alimentation à découpage est donnée par le courant de rétroaction IFB400. Le circuit de détection 1500 est donc adapté à détecter une augmentation du courant de rétroaction IFB400.

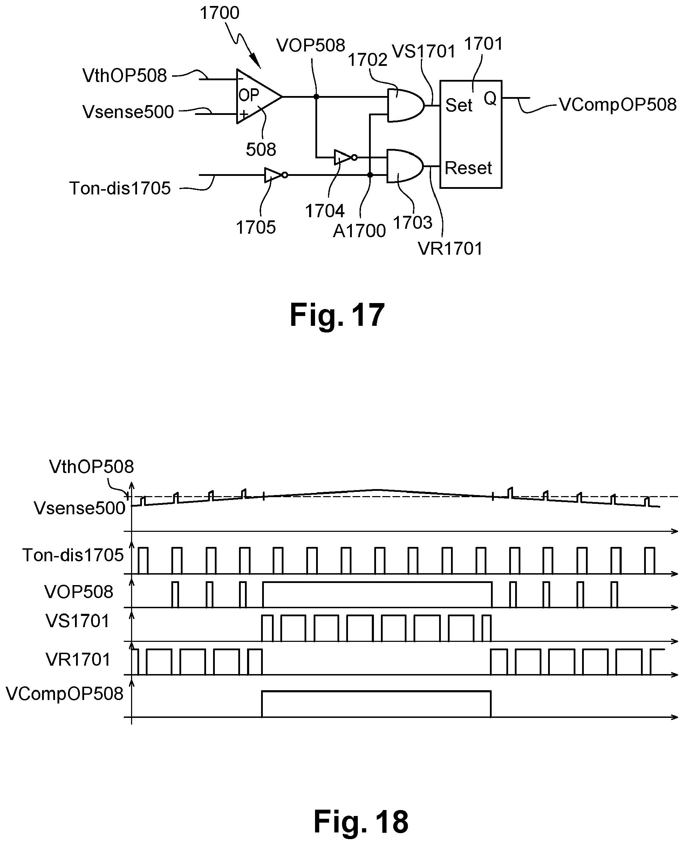

Le circuit de détection 1500 comprend le circuit comparateur 508 et le circuit de filtrage 509. Le circuit comparateur 508 est du type du circuit 508, par exemple du type du circuit comparateur 900 décrit en détail en relation avec la figure 9. Le circuit de filtrage et son fonctionnement sont décrits en détails en relation avec les figures 17 à 20.

Comme dit précédemment, le circuit comparateur 508 (OP) comprend une borne d'entrée non inverseuse (+) reliée à borne 403-IFB, et une borne d'entrée inverseuse (-) recevant la tension de seuil VthOP508. Selon un mode de réalisation, la tension de seuil VthIMAX505 est inférieure à la tension de seuil VthOP508. Le circuit comparateur 505 fournit, en sortie, une tension au circuit de filtrage 509 qui fournit lui-même en sortie la tension de comparaison VCompOP508 au circuit logique 503. Le circuit comparateur 508 permet de détecter une trop haute hausse de courant.

Le circuit de filtrage 509 a pour but de ne prendre en compte le résultat du circuit comparateur 508 que lorsque le transistor de puissance 403 est dans un état ouvert, c'est-à-dire un état non conducteur.

Le circuit de détection 1500 comprend, en outre, un circuit inverseur 1501 et un transistor T1501. Selon un exemple, le transistor T1501 est un transistor de type d-mode. Le circuit inverseur 1501 comprend une borne d'entrée reliée, de préférence connectée, à l'entrée du circuit de pilotage 502, et une borne de sortie reliée, de préférence connectée, à la borne de grille du transistor T1501. Une première borne de conduction du transistor T1501 est reliée, de préférence connectée, à un noeud N1501 reliant une borne de la résistance R501 à une borne de conduction du transistor 501. Une deuxième borne de conduction du transistor T1501 est reliée, de préférence connectée, à la borne 403-GND.

Le fonctionnement de cette détection de surcharge en courant est décrite en relation avec la figure 16.

La figure 16 représente des chronogrammes illustrant le fonctionnement du circuit de détection d'une charge de sortie ouverte de la figure 15.

La figure 16 représente, plus particulièrement, les chronogrammes suivants :

- un chronogramme représentant l'évolution temporelle de la tension de sortie Vout400 de l'alimentation à découpage comprenant le commutateur de puissance 403 ;
- un chronogramme représentant l'évolution temporelle du courant IDRAIN404 ;
- un chronogramme représentant l'évolution temporelle de la tension Vsense500 ; et
- un chronogramme représentant l'évolution temporelle de la tension VCompOP508.

La figure 16 présente deux cas, le cas [Normal] pendant lequel l'alimentation à découpage présente une charge en sortie et pendant lequel la tension Vout400 est constante, et un cas [OP] pendant lequel la charge en sortie est retirée, et pendant lequel la tension Vout400 croît.

Lorsque la tension Vout400 croît, le courant de rétroaction IFB400 croît également, et son image, la tension Vsense500 croît en conséquence. La tension Vsense500 dépasse, dans un premier temps, la tension de seuil VthIMAX505, et la durée des cycles de conduction du transistor de puissance 404 est diminuée petit à petit. Lorsque la tension Vsense500 dépasse la tension de seuil VthOP508 et que le transistor de puissance est dans un état ouvert, la tension VCompOP508 passe à un niveau haut indiquant que la charge de sortie est manquante.

La figure 17 représente un mode de réalisation d'un circuit de filtrage 1700 du circuit de détection 1500 décrit en relation avec la figure 15. En figure 17, sont représentés le circuit de filtrage 1700 et le circuit comparateur 508 (OP).

Le circuit de filtrage 1700 comprend une bascule 1701 de type RS, c'est-à-dire une bascule du même type que la bascule 601 du circuit logique 503. Autrement dit, la bascule 1701 comprend trois bornes parmi lesquelles une borne d'initialisation (set) Set, une borne de réinitialisation (reset) Reset et une borne de sortie Q. La borne de sortie Q fournit la tension de comparaison VCompOP508.

Le circuit de filtrage 1700 comprend, en outre, deux portes logiques 1702 et 1703 de type ET (AND) comprenant, chacune, deux bornes d'entrée et une borne de sortie. Une première borne d'entrée de la porte logique 1702 est reliée, de préférence connectée, à la borne de sortie du circuit comparateur 508. La tension de sortie du circuit comparateur 508 est appelée ci-après VOP58. Une deuxième borne d'entrée de la porte logique 1702 est reliée, de préférence connectée, à un noeud A1700. La borne de sortie de la porte logique 1701 est reliée, de préférence connectée, à la borne Set de la bascule 1701. Une première borne d'entrée de la porte logique 1703 est reliée, de préférence connectée au noeud A1700. La borne de sortie de la porte logique 1702 est reliée, de préférence connectée, à la borne Reset de la bascule 1701.

Le circuit de filtrage 1700 comprend, en outre, un circuit inverseur 1704. Une borne d'entrée du circuit inverseur 1704 est reliée, de préférence connectée, à la borne de sortie du circuit comparateur 508. Une borne de sortie du circuit inverseur 1704 est reliée, de préférence connectée, à une deuxième borne d'entrée de la porte logique 1703.

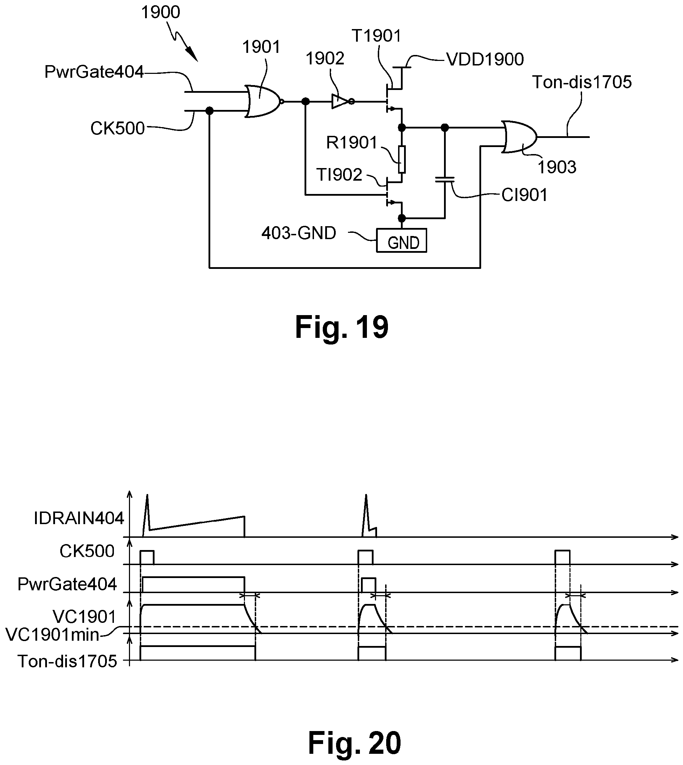

Le circuit de filtrage 1700 comprend, en outre, un circuit inverseur 1705. Une borne d'entrée du circuit inverseur 1705 est reliée, de préférence connectée, à un noeud fournissant une tension de commande Ton_dis1705. Un circuit de génération de la tension de commande Ton_dis1705 est décrit en détails en relation avec la figure 19. Une borne de sortie du circuit inverseur 1705 est reliée, de préférence connectée, au noeud A1700.

Le fonctionnement du circuit de filtrage est décrit en relation avec la figure 18.

La figure 18 représente des chronogrammes illustrant le fonctionnement du circuit de filtrage 1700 de la figure 17.

La figure 18 représente, plus particulièrement, les chronogrammes suivants :

- un chronogramme représentant l'évolution temporelle de la tension Vsense500 ;
- un chronogramme représentant l'évolution temporelle de la tension de commande Ton_dis1705 ;
- un chronogramme représentant l'évolution temporelle de la tension VOP508 ;
- un chronogramme représentant l'évolution temporelle d'une tension VS1701 prise au niveau de la borne d'entrée Set de la bascule 1701 ;
- un chronogramme représentant l'évolution temporelle d'une tension VR1701 prise au niveau de la borne d'entrée Reset de la bascule 1701 ;
- un chronogramme représentant l'évolution temporelle de la tension VCompOP508.

Lorsque la tension Vsense500 dépasse la tension de seuil VthOP508, la tension VOP508 passe à un état haut. La tension de commande Ton_dis1705 est à un état haut à chaque fois que le circuit de pilotage demande au transistor de puissance 404 de passer à l'état fermé, c'est-à-dire l'état conducteur. Les tensions VOP508 et Ton_dis1705 sont combinés pour que la tension de comparaison VCompOP508 ne prenne en compte les états hauts de la tension VOP508 que lorsque que le transistor de puissance est à l'état ouvert.

La figure 19 représente un mode de réalisation d'un circuit 1900 de génération du signal de commande Ton_dis1705 du circuit de filtrage 1700 de la figure 17.

Le circuit 1900 comprend une porte logique 1901 de type NON-OU (NOR) comprenant deux bornes d'entrées et une borne de sortie. Une première borne d'entrée de la porte logique 1901 reçoit une tension PwrGate404 correspondant à la tension de commande appliquée à la borne de grille du transistor de puissance 404. Une deuxième borne

13

d'entrée de la porte logique 1901 reçoit la tension d'horloge CK500.

Le circuit 1900 comprend, en outre, un circuit inverseur comprenant une borne d'entrée reliée, de préférence connectée, à la borne de sortie de la porte logique 1901.

Le circuit 1900 comprend, en outre, un transistor T1901 de type e-mode, une résistance R18901 et un transistor T1902 de type e-mode. Une première borne de conduction du transistor T1901 est reliée, de préférence connectée, à un noeud fournissant une tension d'alimentation VDD1900. Une deuxième borne de conduction du transistor T1901 est reliée, de préférence connectée, à une première borne de la résistance R1901. La borne de grille du transistor T1901 est reliée, de préférence connectée, à la borne de sortie du circuit inverseur 1902. Une deuxième borne de la résistance R1901 est reliée, de préférence connectée, à une première borne de conduction du transistor T1902. Une deuxième borne de conduction du transistor T1902 est reliée, de préférence connectée, à la borne 403-GND. La borne de grille du transistor T1902 est reliée, de préférence connectée, à la borne de sortie de la porte logique 1901.

Le circuit 1900 comprend, en outre, un condensateur C1901 reliant la noeud milieu entre le transistor T1901 et la résistance R191 et la borne 403-GND.

Pour finir, le circuit 1900 comprend, en outre, une porte logique 1903 de type OU (OR) comprenant deux bornes d'entrée et une borne de sortie. Une première borne d'entrée de la porte logique 1903 est reliée, de préférence connectée, au noeud milieu entre le transistor T1901 et la résistance R191 et la borne 403-GND. Une deuxième borne d'entrée de la porte logique 1903 reçoit la tension d'horloge CK500. La borne de sortie de la porte logique 1903 fournit la tension de commande Ton_dis1705.

La figure 20 représente des chronogrammes illustrant le fonctionnement du circuit 1900 de la figure 19.

La figure 20 représente, plus particulièrement, les chronogrammes suivants :

- un chronogramme représentant l'évolution temporelle du courant IDRAIN404 ;
- un chronogramme représentant l'évolution temporelle de la tension d'horloge CK500 ;
- un chronogramme représentant l'évolution temporelle de la tension PwrGate404 ;
- un chronogramme représentant l'évolution temporelle d'une tension VC1901 prise entre les bornes du condensateur C1901 ; et
- un chronogramme représentant l'évolution temporelle de la tension Ton_dis1705.

La tension de commande Ton_dis1705 est générée par la charge et la décharge du condensateur C1901. Plus particulièrement, un front montant de la tension de commande Ton_dis1705 est déclenchée par un front montant de la tension d'horloge CK500, et un front descendant de la tension de commande Ton_dis1705 est déclenchée par une baisse de tension de la tension aux bornes du condensateur C1901. Plus particulièrement, quand la tension VC1901 diminue et devient inférieure à une tension limite VC1901lim, la tension de commande Ton_dis1705 présente un front descendant.

Pour cela, le condensateur C1901 est chargé à chaque front montant de la tension d'horloge CK500, et est déchargé à chaque front descendant de la tension PwrGate404 ou à chaque front descendant de la tension d'horloge CK500.

Ainsi, la tension de commande Ton_dis1705 est représentative d'une phase de conduction du transistor de puissance 404.

La figure 21 représente un mode de réalisation d'un circuit 2100 de détection d'un court-circuit en sortie de l'alimentation à découpage 400 de la figure 4, c'est-à-dire un court-circuit entre les noeuds OUT401 et OUT402. Le circuit 2100 est aussi appelé circuit de détection d'un court-circuit de sortie.

Comme expliqué en relation avec la figure 5, le circuit de commande 500 du transistor de puissance 404 comprend le circuit comparateur 506 et le circuit de filtrage 507 permettant tous deux de détecter un court-circuit en sortie de l'alimentation à découpage, c'est-à-dire un court-circuit entre les noeuds OUT401 et OUT402. Un court-circuit en sortie se traduit par une tension de sortie Vout qui diminue et donc par une diminution du courant de rétroaction IFB7400. En effet, comme dit précédemment, l'image de la tension de sortie de l'alimentation à découpage est donnée par le courant de rétroaction IFB400.

Le circuit de détection 2100 comprend le circuit comparateur 506 et le circuit de filtrage 507. Le circuit comparateur 506 est du type du circuit 505, par exemple du type du circuit comparateur 900 décrit en détail en relation avec la figure 9. Le circuit de filtrage 507 est du type du circuit de filtrage 1700 décrit en relation avec les figures 17 à 20.

Comme dit précédemment, le circuit comparateur 506 (OV) comprend une borne d'entrée non inverseuse (+) reliée à borne 403-IFB, et une borne d'entrée inverseuse (-) recevant la tension de seuil VthOV506. Selon un mode de réalisation, la tension de seuil VthOV506 est inférieure à la tension de seuil VthIMAX505. Le circuit comparateur 506 fournit, en sortie, une tension au circuit de filtrage 507. Le circuit comparateur 506 permet de détecter une diminution du courant de rétroaction IFB400.

Le circuit de filtrage 507 a pour but de ne prendre en compte le résultat du circuit comparateur 506 que lorsque le transistor de puissance 403 est dans un état ouvert, c'est-à-dire un état non conducteur.

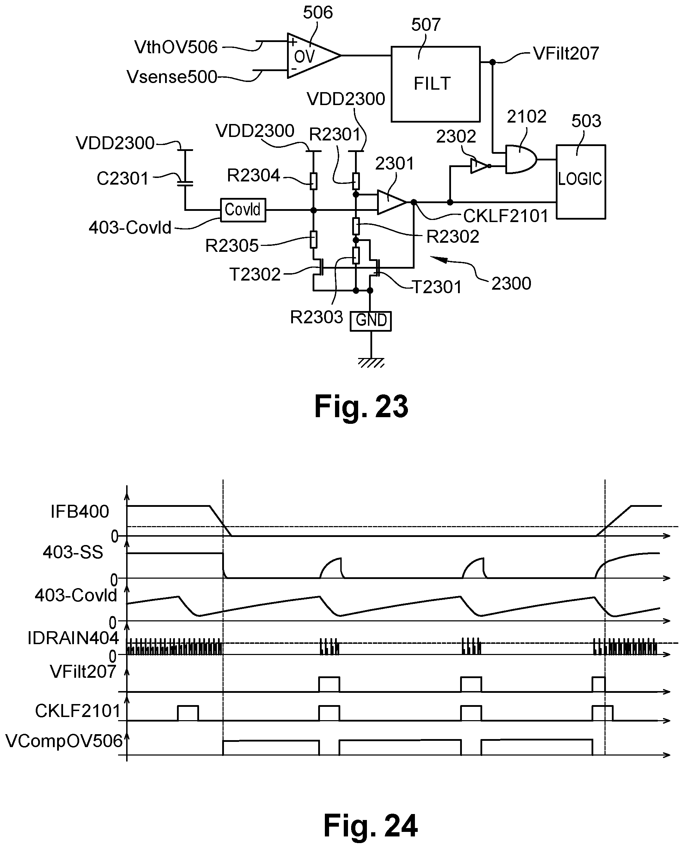

Le circuit de détection 2100 comprend, en outre, un circuit oscillant basse fréquence 2101. Le circuit 2101 fournit en sortie une tension CKLF2101. Le circuit 2101 peut fournir la tension CKLF2101 au circuit logique 503. Un exemple de réalisation du circuit 2101 est décrit en relation avec la figure 23.

Le circuit de détection 2100 comprend, en outre, une porte logique 2102 de type ET (AND) comprenant deux bornes d'entrée et une borne de sortie. Une première borne d'entrée de la porte logique 2102 est reliée, de préférence connectée, à une sortie du circuit de filtrage 507. Une deuxième borne d'entrée de la porte logique 2102 est reliée, de préférence connectée, à la borne de sortie du circuit 2101, et reçoit donc la tension CKLF2101. La borne de sortie de la porte logique 2102 fournit la tension de comparaison VCompOV506 au circuit logique 503 (LOGIC).

Le fonctionnement de cette détection d'un court-circuit est décrite en relation avec la figure 22.

La figure 22 représente des chronogrammes illustrant le fonctionnement du circuit de détection d'un court-circuit de sortie 2100 de la figure 21.

La figure 22 représente, plus particulièrement, les chronogrammes suivants :

- un chronogramme représentant l'évolution temporelle de la tension de sortie Vout400 de l'alimentation à découpage comprenant le commutateur de puissance 403 ;
- un chronogramme représentant l'évolution temporelle du courant IDRAIN404 ;
- un chronogramme représentant l'évolution temporelle de la tension Vsense500 ; et
- un chronogramme représentant l'évolution temporelle de la tension VCompOV506.

La figure 22 présente deux cas, le cas [Normal] pendant lequel l'alimentation à découpage fonctionnement normalement et pendant lequel la tension Vout400 est constante, et un cas [OV] pendant lequel un court-circuit est détecté en sortie, et pendant lequel la tension Vout400 décroît.

Lorsque la tension Vout400 décroît, le courant de rétroaction IFB400 décroît également, et son image, la tension Vsense500 décroît en conséquence. La tension Vsense500 décroît jusqu'à atteindre la tension de seuil VthOV506. La tension de comparaison VCompOV506 détecte alors la chute de tension de la tension Vsense500, et les cycles de conduction du transistor de puissance 404 sont arrêtés.

La figure 23 représente un circuit oscillant 2300 pouvant être utilisé comme circuit oscillant du mode de réalisation du circuit 2100 décrit en relation avec la figure 21.

En figure 23 sont représentés le comparateur 506, le circuit de filtrage 507, le circuit logique 503, la porte logique 2102, et le circuit 2300 décrit ci-après.

Le circuit 2300 comprend un circuit comparateur 2301 du type des circuits comparateurs 505, 506 et 508 de la figure 5, et par exemple du type du circuit comparateur 900 décrit en détail en relation avec la figure 9. Le circuit comparateur 2301 comprend une borne d'entrée non inverseuse et une borne d'entrée inverseuse. Le circuit comparateur 2301 comprend, en outre, une borne de sortie fournissant la tension CKLF2101, et étant reliée, de préférence connectée, au circuit logique 503.

Le circuit 2300 comprend, en outre, un circuit inverseur 2302. Le circuit inverseur 2302 comprend une borne d'entrée recevant la tension CKLF2101, et une borne de sortie reliée, de préférence connectée, à une borne d'entrée de la porte logique 2102.

Le circuit 2300 comprend, en outre, un premier pont diviseur de tension comportant une résistance R2301, une résistance R2302 et une résistance R2303. Le premier pont diviseur de tension est relié à la borne d'entrée inverseuse du circuit comparateur 2301. Une première borne de la résistance R2301 est reliée, de préférence connectée, à un noeud fournissant une tension d'alimentation VDD2300, et une deuxième borne de la résistance R2301 est reliée, de préférence connectée, à la borne d'entrée inverseuse du circuit comparateur 2301. Une première borne de la résistance R2302 est reliée, de préférence connectée, à la borne d'entrée inverseuse du circuit comparateur 2301, et une deuxième borne de la résistance R2302 est reliée, de préférence connectée, à une première borne de la résistance R2303. Une deuxième borne de la résistance R2303 est reliée, de préférence connectée, à la borne 403-GND.

Le circuit 2300 comprend, en outre, une résistance R2304 et une résistance R2305. Les résistances R2304 et R2305 sont des résistances de tirage. Plus particulièrement, la résistance R2304 est une résistance de tirage vers un niveau haut (pull-up résistance), et la résistance R2305 est une résistance de tirage vers un niveau bas (pull-down résistance). Pour cela la valeur de la résistance R2304 est plus élevée que la valeur de la résistance R2305. Une première borne de la résistance R2304 est reliée, de préférence connectée, au noeud fournissant la tension d'alimentation VDD2300, et une deuxième borne de la résistance R2304 est reliée, de préférence connectée, à la borne d'entrée non inverseuse du circuit comparateur 2301. Une première borne de la résistance R2305 est reliée, de préférence connectée, à la borne d'entrée non inverseuse du circuit comparateur 2301.

Le circuit 2300 comprend, en outre, deux transistors T2301 et T2302. Les transistors T2301 et T2302 sont tous deux des transistors de type e-mode. Une première borne de conduction du transistor T2301 est reliée, de préférence connectée, au noeud milieu entre les résistances R2302 et R2303, et une deuxième borne de conduction du transistor T2301 est reliée, de préférence connectée, à la borne 403-GND. Une première borne de conduction du transistor T2302 est reliée, de préférence connectée, à une deuxième borne de la résistance R2305, et une deuxième borne de conduction du transistor T2301 est reliée, de préférence connectée, à la borne 403-GND. Les bornes de grilles des transistors T2301 et T2302 sont reliées, de préférence connectées, à la borne de sortie du circuit comparateur 2301.

Le circuit 2300 comprend, en outre, un condensateur 2301 comportant une première borne reliée, de préférence connectée, au noeud fournissant la tension d'alimentation VDD2300 et une deuxième borne reliée, de préférence connectée, à une borne 403-Covld. La borne 403-Covld est, elle-même, reliée, de préférence connectée, à la borne non inverseuse du circuit comparateur 2301.

Le fonctionnement du circuit 2300 est similaire au fonctionnement du circuit oscillant 700 décrit en relation avec les figures 7 et 8.

La figure 24 représente des chronogrammes illustrant, plus en détails le fonctionnement du circuit de détection de court-circuit 2100 décrit en relation avec les figures 21 à 23. Le figure 24 illustre, plus en détails, le principe de limitation de puissance lié à la détection d'un court-circuit en sortie ainsi que les tentatives de redémarrage associés.

La figure 24 représente, plus particulièrement, les chronogrammes suivants :

- un chronogramme représentant l'évolution temporelle du courant de rétroaction IFB400 ;
- un chronogramme représentant l'évolution temporelle de la tension prise au niveau de la borne 403-SS ;
- un chronogramme représentant l'évolution temporelle de la tension prise au niveau de la borne 403-403-Covld ;
- un chronogramme représentant l'évolution temporelle du courant IDRAIN404 ;
- un chronogramme représentant l'évolution temporelle de la tension de sortie VFilt207 du circuit de filtrage 207 ;
- un chronogramme représentant l'évolution temporelle de la tension CKLF2101 ; et
- un chronogramme représentant l'évolution temporelle de la tension VCompOV506.

Comme dit précédemment, le circuit 2100 surveille une chute de courant du courant IFB400, qui correspond à une chute de tension de la tension Vsense500. Le circuit de filtrage 207 permet de ne prendre en compte les chutes de tension de la tension Vsense500 survenant pendant une phase de non-conduction du transistor de puissance 404. Le circuit oscillant à basse fréquence 2101 permet de définir la durée d'une phase de non-conduction du transistor de puissance 404.

La figure 25 représente un premier exemple de réalisation d'un circuit 2500 de génération des tensions de seuil utilisées par le circuit de commande 500 décrit en relation avec la figure 5.

En figure 25 sont représentés les circuits comparateurs 505, 506 et 508, le transistor de puissance 404 et le circuit 2500 décrit ci-après.

Le circuit 2500 est adapté à fournir les tensions de seuil VthIMAX505, VthOP508 et VthOV206 utilisées par les circuits comparateurs 505, 506 et 508.

Le circuit 2500 comprend deux résistances R2501 et R2502. Une première borne de la résistance R2501 est reliée, de préférence connectée, à la borne 403-SS et est reliée, de préférence connectée, à la borne d'entrée inverseuse du circuit comparateur 508. Une deuxième borne de la résistance R2501 est reliée, de préférence connectée, à la borne d'entrée inverseuse du circuit comparateur 505. Une première borne de la résistance R2502 est reliée, de préférence connectée, à la borne d'entrée inverseuse du circuit comparateur 505.

Le circuit 2500 comprend, en outre, deux transistors T2501 et T2502 de type e-mode. Une première borne de conduction du transistor T2501 est reliée, de préférence connectée, à une deuxième borne de la résistance R2502, et une deuxième borne de conduction du transistor T2501 est reliée, de préférence connectée, à la borne d'entrée inverseuse du circuit comparateur 506. Une première borne de conduction du transistor T2502 est reliée, de préférence connectée, à la borne d'entrée inverseuse du circuit comparateur 506, et une deuxième borne de conduction du transistor T2502 est reliée, de préférence connectée, à la borne 403-GND, représentée en figure 25 par la masse. Les bornes de commande des transistors T2501 et T2502 sont toutes deux reliées, de préférence connectées, à un noeud fournissant une tension d'alimentation VDD2500.

Le circuit 2500 comprend, en outre, une résistance R2503. Une première borne de la résistance R2503 est reliée, de préférence connectée, à la borne 403-SS. Une deuxième borne de la résistance R2501 est reliée, de préférence connectée, au noeud fournissant la tension d'alimentation VDD2500.

La figure 26 représente un deuxième exemple de réalisation d'un circuit 2600 de génération des tensions de seuil utilisées par le circuit de commande 500 décrit en relation avec la figure 5.

En figure 26 sont représentés les circuits comparateurs 505, 506 et 508, le transistor de puissance 404 et le circuit 2600 décrit ci-après.

Le circuit 2600 est adapté à fournir les tensions de seuil VthIMAX505, VthOP508 et VthOV206 utilisées par les circuits comparateurs 505, 506 et 508.

Le circuit 2600 comprend tous les éléments du circuit 2500 décrit en relation avec la figure 25. Ces éléments ne sont pas décrits de nouveau ici. Seules les différences entre les circuits 2500 et 2600 sont mises en exergue.

Ainsi, le circuit 2600 comprend, en outre, un transistor T2601 de type e-mode et un condensateur C2601. Une première borne de conduction du transistor T2601 est reliée, de préférence connectée, à la borne 403-SS. Une deuxième borne de conduction du transistor T2601 est reliée, de préférence connectée, à la borne 403-GND, représentée par la masse en figure 26. Une borne de commande du transistor T2601 est reliée, de préférence connectée, à la sortie du circuit de détection d'un court-circuit. Autrement dit, la borne de commande du transistor 2601 reçoit la tension VCompOV506. Une première borne du condensateur C2601 est reliée, de préférence connectée, à la borne 403-SS, et une deuxième borne du condensateur C2601 est reliée, de préférence connectée, à la borne 403-GND.

La figure 27 représente un mode de réalisation d'une alimentation à découpage 2700 comprenant un exemple du mode de réalisation du commutateur de puissance 403 décrit en relation avec la figure 4.

L'alimentation à découpage 2700 comprend un noeud d'entrée 2700IN et un noeud de sortie 2700OUT.

Comme décrit précédemment, le commutateur de puissance 403 comprend un transistor de puissance 404 et un circuit de commande 403 détaillé en figure 27. Pour rappel, le commutateur de puissance 403 est formé dans et sur une structure du type de la structure 100 décrite en relation avec la figure 1. Le circuit de commande 403 comprend des éléments déjà décrits, parmi lesquels :

- le circuit de pilotage 502 ;
- le circuit logique 503 ;
- le circuit oscillant 504 ;
- les circuits comparateurs 505, 506, et 508 ;
- le circuit de détection d'un court-circuit 2100 ; et
- le transistor 501.

Le circuit de commande 403 comprend plusieurs bornes de connexion parmi lesquelles :

- la borne 403-DRAIN (DRAIN) ;
- la borne 403-GND (GND) ;
- une borne TAB ;
- la borne 403-IFB (IFB) ;
- la borne 403-SS (SS) ;
- une borne CLK_C ;
- une borne CLK_R ;
- une borne dV/dt_ctrl ;
- une borne VDD ;
- une borne DZ6V ;
- une borne VCC ; et
- une borne SUPPLY.

Le circuit de commande 403 comprend, en outre, des circuits d'alimentation 2701 (REG) et 2702 (VCC_SUP). Ces circuits ont pour objet de fournir la ou les tensions d'alimentation des autres circuits du circuit de commande 403. Selon un exemple, le circuit 2702 est relié à la borne SUPPLY. Selon un exemple, le circuit 2701 est relié au circuit 2701, à la borne VCC, et à la borne DZ6V.

Le circuit de commande 403 comprend, en outre, un circuit de détection 2703 (UV) d'une chute de tension de la ou les tensions d'alimentation fournies par les circuits d'alimentation 2701 et 2702. Ce circuit 2703 est, par exemple, relié aux circuits 2701 et 2702, mais aussi au circuit logique 503.

Le circuit de commande 403 comprend, en outre, un circuit de détection 2704 (OT) d'une surchauffe. Selon un exemple, le circuit de détection 2704 est relié, de préférence connecté, au circuit logique 503.

Le circuit de commande 403 comprend, en outre, des circuits de protection 2705 contre les décharges électrostatiques. Chaque circuit 2705 est associé à une borne de connexion du circuit de commande 403.

Une personne du métier saura mettre en oeuvre les circuits 2701, 2702, 2703, 2704 et 2705. A titre d'exemple, des exemples de réalisation de certain de ces circuits sont donnés dans la demande de brevet français référencée FR2210660.

Le circuit de commande 403 comprend, en outre, des composants électroniques qui, en figure 27, ne sont pas formés sur une structure du type de la structure 100 décrite en relation avec la figure 1. Certain de ces composants, comme les résistances et les condensateurs, pourraient est être formé sur la même structure que le reste du circuit de commande 403, mais ne le sont pas ici pour permettre une adaptation plus aisée des paramètres de l'alimentation à découpage 2700.

Ainsi, le circuit de commande 403 comprend un condensateur C2701 dont une première borne est reliée, de préférence connectée à la borne d'entrée 2700IN et à la borne SUPPLY du circuit de commande 403. Une deuxième borne du condensateur C2701 reçoit une tension de référence.

Le circuit de commande 403 comprend, en outre, une diode Zener DZ2701. La cathode de la diode Zener DZ2701 est reliée, de préférence connectée, à une borne fournissant un courant de polarisation dédié à la diode Zener DZ2701. L'anode de la diode Zener DZ2701 reçoit une tension de référence.

Le circuit de commande 403 comprend, en outre, un condensateur C2702 dont une première borne est reliée, de préférence connectée à la borne VDD. Une deuxième borne du condensateur C2702 reçoit une tension de référence.

Le circuit de commande 403 comprend, en outre, une résistance R2701 et un condensateur C2704. Une première borne de la résistance R2701 est reliée, de préférence connectée, à la borne VDD, et une deuxième borne de la résistance R2701 est reliée, de préférence connectée, à une première borne du condensateur C2704 et à la borne 403-SS. Une deuxième borne du condensateur C2705 reçoit une tension de référence.

Le circuit de commande 403 comprend, en outre, une résistance R2702, un condensateur C2705, et une résistance R2703. Une première borne de la résistance R2702 est reliée, de préférence connectée, à la borne VDD, et une deuxième borne de la résistance R2702 est reliée, de préférence connectée, à une première borne du condensateur C2705 et à la borne CLK_C. Une deuxième borne du condensateur C2705 reçoit une tension de référence. Une première borne de la résistance R2703 est reliée, de préférence connectée, à la borne CLK_R. Une deuxième borne de la résistance R2703 est reliée, de préférence connectée, à la borne CLK_C.

Le circuit de commande 403 comprend, en outre, une résistance R2704 dont une première borne est reliée, de préférence connectée à la borne VDD. Une deuxième borne de la résistance R2704 est reliée, de préférence connectée, à la borne dV/dt_ctrl.

Le circuit de commande 403 comprend, en outre, une résistance R2705 dont une première borne est reliée, de préférence connectée à la borne IFB. Une deuxième borne de la résistance R2705 reçoit une tension de référence.

L'alimentation à découpage 2700 comprend, en outre, un transformateur 2706 comprenant une bobine d'entrée et deux bobines de sortie. Une première borne de la bobine d'entrée est reliée, de préférence connectée, à la borne d'entrée 2700IN, et une deuxième borne de la bobine d'entrée est reliée, de préférence connectée, à la borne 403-DRAIN. Les deux bobines de sortie comprennent toutes les deux une première borne recevant une tension de référence. Une deuxième borne d'une première bobine de sortie est reliée au noeud de sortie 2700OUT par l'intermédiaire d'une diode D2702 décrite ci-après. Une deuxième borne d'une deuxième bobine de sortie est reliée à la borne VCC par l'intermédiaire d'une diode D2703 décrite ci-après.

L'alimentation à découpage 2700 comprend, en outre, une diode Zener DZ2702 et une diode D2701 montées tête-bêche entre la borne d'entrée 2700IN et la borne 403-DRAIN. Plus particulièrement, l'anode de la diode Zener DZ2702 est reliée, de préférence connectée, à la borne d'entrée 2700IN. La cathode de la diode Zener DZ2702 est reliée, de préférence connectée, à la cathode de la diode D2701. L'anode de la diode D2701 est reliée, de préférence connectée, à la borne 403-DRAIN.

L'alimentation à découpage 2700 comprend, en outre, les diodes D2702 et D2703 et un condensateur C2706. L'anode de la diode D2702 est reliée, de préférence connectée, à la première diode de sortie du transformateur 2706, et la cathode de la diode D2702 est reliée, de préférence connectée, à la borne de sortie 2700OUT. L'anode de la diode D2703 est reliée, de préférence connectée, à la deuxième diode de sortie du transformateur 2706, et la cathode de la diode D2703 est reliée, de préférence connectée, à la borne VCC. Une première borne du condensateur C2706 est reliée, de préférence connectée, à la borne VCC, et une deuxième borne du condensateur C2703 reçoit une tension de référence.

L'alimentation à découpage 2700 comprend, en outre, une résistance R2706, un optocoupleur 2707 et une diode Zener DZ2703. L'optocoupleur 2707 comporte une diode électroluminescente DEL2707 et un opto-transistor bipolaire OT2707. Une première borne de la résistance R2706 est reliée, de préférence connectée, à la borne de sortie 2700OUT, et une deuxième borne de la résistance R2706 est reliée, de préférence connectée, à l'anode de la diode DEL2707. La cathode de la diode DEL2707 est reliée, de préférence connectée, à la cathode de la diode Zener DZ2703. L'anode de la diode ZenerDZ2703 reçoit une tension de référence. Le collecteur du transistor OT2707 est relié, de préférence connecté, à la borne VDD, et l'émetteur du transistor OT2707 est relié, de préférence connecté, à la borne 403-IFB. L'optocoupleur 2707 forme le composant de base du circuit de rétroaction 406 décrit en relation avec la figure 4.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

**Revendications**

1. Circuit de modulation de largeur d'impulsion (405) d'une alimentation à découpage (400) formé dans et sur un substrat semiconducteur monolithique (101) ayant une face recouverte d'une couche de Nitrure de Gallium (102), ledit circuit étant adapté à commander un transistor de puissance (404) de ladite alimentation à découpage.

2. Circuit selon la revendication 1, comprenant un premier circuit comparateur (505) d'une première tension (Vsense500) représentative d'un courant de drain dudit transistor et d'un courant de rétroaction (IFB400) de ladite alimentation à découpage.

3. Circuit selon la revendication 2, dans lequel ledit premier circuit comparateur (505) est adapté à rendre ledit transistor (404) non conducteur si ladite première tension (Vsense500) est supérieure à une première tension de seuil (VthIMAX505).

4. Circuit selon l'une quelconque des revendications 1 à 3, comprenant, en outre, un deuxième circuit comparateur (506) de ladite première tension (Vsense500) représentative du courant de drain dudit transistor (404) et d'un courant de rétroaction (IFB400) de ladite alimentation à découpage.

5. Circuit selon la revendication 4, dans lequel ledit deuxième circuit comparateur (506) est adapté à rendre ledit transistor (404) non conducteur si ladite première tension (Vsense500) est inférieure à une deuxième tension de seuil (VthOV506).

6. Circuit selon la revendication 4 ou 5, comprenant, en outre, un premier circuit de filtrage (507) permettant de ne prendre en compte un résultat dudit deuxième circuit comparateur (506) uniquement pendant une phase de non-conduction dudit transistor de puissance (404).

7. Circuit selon l'une quelconque des revendications 1 à 6, comprenant, en outre, un troisième circuit comparateur (508) de ladite première tension (Vsense500) représentative du courant de drain dudit transistor (404) et d'un courant de rétroaction (IFB400) de ladite alimentation à découpage.

8. Circuit selon la revendication 7, dans lequel ledit troisième circuit comparateur (508) est adapté à rendre ledit transistor (404) non conducteur si ladite première tension (Vsense500) est supérieure à une troisième tension de seuil (VthOP508).

9. Circuit selon la revendication 7 ou 8, comprenant, en outre, un deuxième circuit de filtrage (509) permettant de ne prendre en compte un résultat dudit troisième circuit comparateur (509) uniquement pendant une phase de non-conduction dudit transistor de puissance (404).

10. Circuit selon l'une quelconque des revendications 1 à 9, comprenant, en outre, un circuit oscillant (504) adapté à fournir une tension d'horloge (CK500).

11. Circuit selon l'une quelconque des revendications 1 à 10, comprenant, en outre, un circuit logique (503) adapté à recevoir au moins une tension d'horloge (CK500), et au moins une tension de comparaison (VCompIMAX505, VCompOV506, VCompOP508).

12. Circuit selon la revendication 11, comprend, en outre un circuit de pilotage (502) dudit transistor de puissance (404) adapté à recevoir une tension de commande dudit circuit logique (503).

13. Commutateur de puissance (403 ; 500) comprenant un transistor de puissance (404) adapté à recevoir une tension maximale de 650 V entre son drain et sa source, et un circuit de modulation en largeur d'impulsion (405) selon l'une quelconque des revendications 1 à 12.

14. Commutateur selon la revendication 13, dans lequel ledit transistor de puissance est un transistor (404) de type HEMT de type e-mode.

15. Alimentation à découpage (400 ; 2700) comprenant le commutateur de puissance (403 ; 500) selon la revendication 13 ou 14

100

GaN

102

Si

101

## Fig. 1

200

D

G

(A)

S

250

S

254

G

256

D

253

255

AlGaN

252

GaN

251

Si

(B)

## Fig. 2

300

D

G

S

(A)

350

S

G

356

354

D

355

353

AlGaN

352 GaN

351 Si

(B)

# Fig. 3

**Fig. 4**

**Fig. 5**

600

CK500

VCompOP508
VCompOV506
OT604
UV604

604

603

Ton-max602
VCompIMAX505

602

601

S     Q

R

502

Driver

403-DRAIN

DRAIN

404

GND

403-GND

# Fig. 6

Fig. 7

Fig. 8

Fig. 9

**Fig. 10**

Fig. 11

Fig. 12

**Fig. 13**

**Fig. 14**

**Fig. 15**

**Fig. 16**

**Fig. 17**

**Fig. 18**

**Fig. 19**

**Fig. 20**

**Fig. 21**

**Fig. 22**

**Fig. 23**

**Fig. 24**

**Fig. 25**

**Fig. 26**

**Fig. 27**

EP 4 429 095 A1

Europäisches
Patentamt

European
Patent Office

Office européen
des brevets

**RAPPORT DE RECHERCHE EUROPEENNE**

Numéro de la demande

EP 24 16 0121

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2014/071714 A1 (LI EN [CN]) 13 mars 2014 (2014-03-13) * figures 1,2 * ----- | 1-15 | INV. H02M3/335 H01L29/20 |
| A | Anonymous: "Gallium nitride - Wikipedia", , 21 janvier 2019 (2019-01-21), XP055878394, Extrait de l'Internet: URL:https://en.wikipedia.org/w/index.php?title=Gallium_nitride&oldid=879521224 [extrait le 2022-01-12] * le document en entier * ----- | 1-15 | |
| A | KARIM S BOUTROS ET AL: "GaN power electronics for automotive application", ENERGYTECH, 2012 IEEE, IEEE, 29 mai 2012 (2012-05-29), pages 1-4, XP032237326, DOI: 10.1109/ENERGYTECH.2012.6304646 ISBN: 978-1-4673-1836-5 * abrégé * * alinéa [00II] * ----- | 1-15 | |

DOMAINES TECHNIQUES RECHERCHES (IPC)

H02M
H01L

Le présent rapport a été établi pour toutes les revendications

| Lieu de la recherche | Date d'achèvement de la recherche | Examinateur |
|---|---|---|
| La Haye | 11 juillet 2024 | Gotzig, Bernhard |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 16 0121

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-07-2024

| Document brevet cité au rapport de recherche | Date de publication | Membre(s) de la famille de brevet(s) | Date de publication |
|---|---|---|---|
| US 2014071714 A1 | 13-03-2014 | CN 102820764 A<br>US 2014071714 A1 | 12-12-2012<br>13-03-2014 |

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- FR 2210660